# FASCICULE DE BREVET EUROPEEN

(11) **EP 4 435 439 B1**
(45) Date de publication et mention de la délivrance du brevet: **17.09.2025**
(21) Numéro de dépôt: 24164609.0
(22) Date de dépôt: 19.03.2024
(51) Int. Cl.: G01R 19/12, G01R 1/20

(54) **CIRCUIT DE MESURE D'UNE DERIVEE**
SCHALTUNG ZUR MESSUNG EINER ABLEITUNG
DERIVATIVE MEASURING CIRCUIT

(30) Priorité: 24.03.2023 FR 2302835
(43) Date de publication de la demande: 25.09.2024
(73) Titulaire: STMicroelectronics International N.V., 1228 Plan-les-Ouates, Geneva (CH)
(72) Inventeur: CAMIOLO, Jean, 38360 Sassenage (FR); GODET, Geoffroy, 38100 Grenoble (FR)
(74) Mandataire: Cabinet Beaumont

(56) Documents cités:
- EP-A1- 0 416 699
- US-A1- 2015 226 556
- PRAGYA VARSHNEY ET AL: "Implementation of first and third order fractional order differentiators and integrators using switched capacitors", POWER ELECTRONICS (IICPE), 2010 INDIA INTERNATIONAL CONFERENCE ON, IEEE, 28 January 2011 (2011-01-28), pages 1 - 8, XP031929671, ISBN: 978-1-4244-7883-5, DOI: 10.1109/IICPE.2011.5728088

## Description

### Domaine technique

La présente description concerne de façon générale les circuits électroniques, par exemple les circuits intégrés, et, plus particulièrement, un circuit de mesure d'une dérivée et un dispositif comprenant un tel circuit de mesure.

### Technique antérieure

De nombreuses applications connues et dispositifs connus mettent en œuvre une mesure (ou calcul) d'une dérivée, par exemple de la dérivée d'une tension indiquant une valeur d'une grandeur physique telle qu'un courant ou une température.

Pour obtenir une mesure de la dérivée d'une tension, c'est-à-dire une valeur de la dérivée de la tension, une solution consiste à utiliser un amplificateur opérationnel monté en dérivateur de tension. Toutefois, cette solution présente divers inconvénients. En particulier, cette solution n'est pas adaptée pour des larges gammes de fréquence du signal d'entrée de l'amplificateur opérationnel. En outre, cette solution requiert un amplificateur opérationnel ayant une bande passante supérieure à la gamme de fréquence du signal d'entrée.

Une autre solution consiste à utiliser un convertisseur analogique numérique (ADC de l'anglais "Analog to Digital Converter") pour numériser la tension sur laquelle la dérivée va être calculée, et un microprocesseur qui lit la sortie de l'ADC et calcule la dérivée de la tension d'entrée de l'ADC. Toutefois, cette solution est complexe du fait qu'elle nécessite un ADC et un microprocesseur. En outre, le temps de conversion de l'ADC auquel s'ajoute le temps de calcul du microprocesseur peut être trop long, par exemple lorsque des contremesures doivent être mises en œuvre dès que la dérivée dépasse un seuil.

Il existe encore d'autres solutions connues pour mesurer, c'est-à-dire calculer, la dérivée d'une tension, mais, ces solutions connues souffrent elles aussi d'inconvénients. Une de ces solutions est décrit dans EP 0 416 699 A1.

Il existe donc un besoin de pallier tout ou partie des inconvénients des circuits connus de mesure d'une dérivée. Résumé de l'invention

Un mode de réalisation pallie tout ou partie des inconvénients des circuits connus de mesure d'une dérivée.

Un mode de réalisation prévoit un circuit de mesure d'une dérivée comprenant :
M éléments capacitifs, avec M un entier supérieur ou égal à 1, ayant chacun une première borne connectée à une première entrée du circuit de mesure configurée pour recevoir un potentiel de référence ;
M premiers interrupteurs couplant une deuxième borne de chacun des M éléments à un premier noeud configuré pour recevoir une première tension déterminée par une tension sur une deuxième entrée du circuit de mesure couplée au premier noeud ;
un premier circuit configuré pour fournir, à une première sortie du circuit de mesure, une deuxième tension indiquant une valeur d'une différence de tension entre des première et deuxième entrées du premier circuit ;
des deuxièmes interrupteurs couplant la deuxième borne de chacun des M éléments aux entrées du premier circuit ; et
un circuit de commande configuré pour :
   - recevoir un premier signal d'horloge disponible sur une troisième entrée du circuit de mesure ;
   - mettre en œuvre des cycles successifs correspondant chacun à une succession de M périodes d'un deuxième signal d'horloge déterminé par le premier signal d'horloge ; et
   - commander les interrupteurs pour que, à chaque période de chaque cycle :
      la première tension soit mémorisée sur l'un des M éléments capacitifs ; et
      la première entrée du premier circuit reçoive une tension mémorisée à un premier instant sur un des M éléments capacitifs et la deuxième entrée du premier circuit reçoive une tension représentative de la première tension à un deuxième instant différent du premier instant.

Selon un mode de réalisation :
M est égal à 1 ;
la première entrée du premier circuit est couplée au premier noeud ; et
le circuit de commande est configuré pour commander les interrupteurs de sorte que, à chaque période de chaque cycle, la deuxième entrée du premier circuit reçoive la tension mémorisée sur l'élément capacitif à cette période.

Selon un mode de réalisation :
M est égal à 2 ; et
le circuit de commande est configuré pour commander les interrupteurs de sorte que, pour chaque cycle :
   celui des M éléments capacitifs sur lequel est mémorisée la première tension soit différent à chaque période dudit cycle, et
   à chaque période dudit cycle, la deuxième entrée du premier circuit reçoive une tension aux bornes d'un des M éléments capacitifs autre que celui sur lequel s'effectue la mémorisation à cette période, et la première entrée du premier circuit reçoive une tension aux bornes de l'autre des M éléments capacitifs.

Selon un mode de réalisation :
M est égal à 3 ; et
le circuit de commande est configuré pour commander les interrupteurs de sorte que, pour chaque cycle :
   celui des M éléments capacitifs sur lequel est mémorisée la première tension est différent à chaque période dudit cycle, et
   à chaque période dudit cycle, la première entrée du premier circuit reçoive une tension aux bornes d'un des M éléments capacitifs autre que celui sur lequel s'effectue la mémorisation à cette période et la deuxième entrée du premier circuit reçoive une tension aux bornes d'un autre des M éléments capacitifs autre que celui sur lequel s'effectue la mémorisation à cette période.

Selon un mode de réalisation :
M est égal à 3 ;
chaque cycle correspond à une succession de première, deuxième et troisième périodes du deuxième signal d'horloge ; et
le circuit de commande est configuré pour commander les interrupteurs pour que :
   à chaque première période, la première tension soit mémorisée sur le premier élément et les première et deuxième entrées du premier circuit reçoivent des tensions des troisième et deuxième éléments respectivement,
   à chaque deuxième période, la première tension soit mémorisée sur le deuxième élément et les première et deuxième entrées du premier circuit reçoivent des tensions des premier et troisième éléments respectivement, et
   à chaque troisième période, la première tension soit mémorisée sur le troisième élément et les première et deuxième entrées du premier circuit reçoivent des tensions des deuxième et premier éléments respectivement.

Selon un mode de réalisation, les premiers interrupteurs comprennent un premier premier interrupteur couplant la deuxième borne du premier élément au premier noeud, un deuxième premier interrupteur couplant la deuxième borne du deuxième élément au premier noeud et un troisième premier interrupteur couplant la deuxième borne du troisième élément au premier noeud.

Selon un mode de réalisation, le circuit de commande est configuré pour :
à chaque première période, maintenir ouvert les deuxième et troisième premiers interrupteurs et commuter le premier premier interrupteur à l'état passant ;
à chaque deuxième période, maintenir ouvert les troisième et premier premiers interrupteurs et commuter le deuxième premier interrupteur à l'état passant ; et
à chaque troisième période, maintenir ouvert les deuxième et premier premiers interrupteurs et commuter le troisième premier interrupteur à l'état passant.

Selon un mode de réalisation, chaque mémorisation de la première tension sur un élément capacitif a une même durée, par exemple inférieure ou égale à une période du deuxième signal d'horloge, de préférence égale à une demi-période du deuxième signal d'horloge.

Selon un mode de réalisation, les deuxièmes interrupteurs comprennent :
des premier et deuxième deuxièmes interrupteurs couplant la deuxième borne du premier élément respectivement aux première et deuxième entrées du premier circuit ;
des troisième et quatrième deuxièmes interrupteurs couplant la deuxième borne du deuxième élément respectivement aux première et deuxième entrées du premier circuit ; et
des cinquième et sixième deuxièmes interrupteurs couplant la deuxième borne du troisième élément respectivement aux première et deuxième entrées du premier circuit.

Selon un mode de réalisation, le circuit de commande est configuré pour :
à chaque première période, commuter les cinquième et quatrième deuxièmes interrupteurs à l'état passant et maintenir les autres deuxièmes interrupteurs ouverts ;
à chaque deuxième période, commuter les premier et sixième deuxièmes interrupteurs à l'état passant et maintenir les autres deuxièmes interrupteurs ouverts ; et
à chaque troisième période, commuter les troisième et deuxième deuxièmes interrupteurs à l'état passant et maintenir les autres deuxièmes interrupteurs ouverts.

Selon un mode de réalisation, le circuit de mesure comprend un élément capacitif de lissage connecté entre la première entrée du premier circuit et la première entrée du circuit de mesure et un élément capacitif de lissage connecté entre la deuxième entrée du premier circuit et la première entrée du circuit de mesure.

Selon un mode de réalisation, le circuit de mesure comprend en outre un deuxième circuit couplant la deuxième entrée du circuit de mesure au premier noeud, le deuxième circuit étant un circuit tampon.

Selon un mode de réalisation, le circuit de mesure comprend :
un premier comparateur configuré pour comparer la deuxième tension à une tension de seuil positive fournie par le circuit de commande, et pour fournir un premier signal binaire indiquant si la deuxième tension est supérieure à la tension de seuil positive ; et/ou
un deuxième comparateur configuré pour comparer la deuxième tension à une tension de seuil négative fournie par le circuit de commande, et pour fournir un deuxième signal binaire indiquant si la deuxième tension est inférieure à la tension de seuil négative.

Selon un mode de réalisation :
le circuit de mesure comprend le premier comparateur ; et
le circuit de commande est configuré pour adapter la valeur de la tension de seuil positive en fonction de la valeur de la première tension.

Selon un mode de réalisation, le circuit de commande est configuré pour diminuer la valeur de la tension de seuil positive lorsque la première tension est positive et augmente.

Selon un mode de réalisation :
le circuit de mesure comprend le deuxième comparateur ; et
le circuit de commande est configuré pour adapter la valeur de la tension de seuil négative en fonction de la valeur de la première tension.

Selon un mode de réalisation, le circuit de commande est configuré pour diminuer la valeur absolue de la tension de seuil négative lorsque la première tension est négative et décroît.

Un autre mode de réalisation prévoit un circuit de mesure d'une dérivée comprenant :
des premier, deuxième et troisième éléments capacitifs ayant chacun une première borne connectée à une première entrée du circuit de mesure configurée pour recevoir un potentiel de référence ;
des premiers interrupteurs couplant une deuxième borne de chacun desdits éléments à un premier noeud configuré pour recevoir une première tension déterminée par une deuxième tension sur une deuxième entrée du circuit de mesure à laquelle le premier noeud est couplé ;
un premier circuit configuré pour fournir, à une première sortie du circuit de mesure, une troisième tension indiquant une valeur d'une différence de tension entre des première et deuxième entrées du premier circuit ;
des deuxièmes interrupteurs couplant la deuxième borne de chacun desdits éléments aux entrées du premier circuit ; et un circuit de commande configuré pour :
   - recevoir un premier signal d'horloge disponible sur une troisième entrée du circuit de mesure ;
   - mettre en œuvre des cycles successifs correspondant chacun à une succession de première, deuxième et troisième périodes d'un deuxième signal d'horloge déterminé par le premier signal d'horloge ; et
   - commander les interrupteurs pour que :
      à chaque première période, la première tension soit mémorisée sur le premier élément et les première et deuxième entrées du premier circuit reçoivent des tensions des troisième et deuxième éléments respectivement,
      à chaque deuxième période, la première tension soit mémorisée sur le deuxième élément et les première et deuxième entrées du premier circuit reçoivent des tensions des premier et troisième éléments respectivement, et
      à chaque troisième période, la première tension soit mémorisée sur le troisième élément et les première et deuxième entrées du premier circuit reçoivent des tensions des deuxième et premier éléments respectivement.

Selon un mode de réalisation, on prévoit un dispositif comprenant une puce de circuit intégré comprenant le circuit de mesure ci-dessus, une résistance commandable externe à la puce et ayant une entrée de commande configurée pour recevoir un signal de commande déterminé au moins en partie par la première sortie du circuit de mesure, et un deuxième circuit connecté à la résistance commandable et configuré pour fournir, à la deuxième entrée du circuit de mesure, la deuxième tension indiquant une valeur du courant dans la résistance commandable, le deuxième circuit faisant par exemple partie de la puce.

Selon un mode de réalisation, les premiers interrupteurs comprennent un premier premier interrupteur couplant la deuxième borne du premier élément au premier noeud, un deuxième premier interrupteur couplant la deuxième borne du deuxième élément au premier noeud et un troisième premier interrupteur couplant la deuxième borne du troisième élément au premier noeud.

Selon un mode de réalisation, le circuit de commande est configuré pour :
à chaque première période, maintenir ouvert les deuxième et troisième premiers interrupteurs et commuter le premier premier interrupteur à l'état passant ;
à chaque deuxième période, maintenir ouvert les troisième et premier premiers interrupteurs et commuter le deuxième premier interrupteur à l'état passant ; et
à chaque troisième période, maintenir ouvert les deuxième et premier premiers interrupteurs et commuter le troisième premier interrupteur à l'état passant.

Selon un mode de réalisation, chaque mémorisation de la première tension sur un élément capacitif a une même durée, par exemple inférieure ou égale à une période du deuxième signal d'horloge, de préférence égale à une demi-période du deuxième signal d'horloge.

Selon un mode de réalisation, ladite même durée est la durée d'état passant des premier, deuxième et troisième premiers interrupteurs pendant chacune des première, deuxième et troisième périodes respectivement.

Selon un mode de réalisation, les deuxièmes interrupteurs comprennent :
des premier et deuxième deuxièmes interrupteurs couplant la deuxième borne du premier élément respectivement aux première et deuxième entrées du premier circuit ;
des troisième et quatrième deuxièmes interrupteurs couplant la deuxième borne du deuxième élément respectivement aux première et deuxième entrées du premier circuit ; et
des cinquième et sixième deuxièmes interrupteurs couplant la deuxième borne du troisième élément respectivement aux première et deuxième entrées du premier circuit.

Selon un mode de réalisation, le circuit de commande est configuré pour :
à chaque première période, commuter les cinquième et quatrième deuxièmes interrupteurs à l'état passant et maintenir les autres deuxièmes interrupteurs ouverts ;
à chaque deuxième période, commuter les premier et sixième deuxièmes interrupteurs à l'état passant et maintenir les autres deuxièmes interrupteurs ouverts ; et
à chaque troisième période, commuter les troisième et deuxième deuxièmes interrupteurs à l'état passant et maintenir les autres deuxièmes interrupteurs ouverts.

Selon un mode de réalisation, le circuit de mesure comprend un élément capacitif de lissage connecté entre la première entrée du premier circuit et la première entrée du circuit de mesure et un élément capacitif de lissage connecté entre la deuxième entrée du premier circuit et la première entrée du circuit de mesure.

Selon un mode de réalisation, le circuit de mesure comprend en outre un troisième circuit couplant la deuxième entrée du circuit de mesure au premier noeud, le troisième circuit étant un circuit tampon configuré pour recevoir la deuxième tension et fournir la première tension.

Selon un mode de réalisation, le circuit de mesure comprend en outre un quatrième circuit couplé, de préférence connecté, aux première et deuxième entrées du premier circuit, le quatrième circuit étant configuré pour fournir, à une deuxième sortie du circuit de mesure, un signal indiquant laquelle des tensions des première et deuxième entrées du premier circuit est supérieure à l'autre.

Selon un mode de réalisation, le circuit de mesure comprend en outre un cinquième circuit configuré pour comparer la troisième tension à un premier seuil et pour fournir, à une troisième sortie du circuit de mesure, un signal indiquant un résultat de la comparaison.

Selon un mode de réalisation :
la résistance commandable comprend plusieurs premières résistances en série et des interrupteurs commandés par le signal de commande de la résistance commandable et configurés chacun pour court-circuiter un nombre donné des premières résistances ;
le deuxième circuit est configuré pour comparer, pour chacune des premières résistances, une tension aux bornes de cette première résistance à au moins un seuil correspondant ; et
le dispositif comprend en outre un sixième circuit configuré pour fournir le signal de commande de la résistance à partir des résultats desdites comparaisons et de la deuxième sortie du circuit de mesure, le sixième circuit faisant, par exemple, partie de la puce.

Selon un mode de réalisation, le dispositif comprend un circuit de traitement, par exemple un microprocesseur, couplé aux première et troisième sorties du circuit de mesure et configuré pour recevoir la deuxième tension.

Selon un mode de réalisation, le dispositif comprend un quatrième élément capacitif connecté en parallèle du premier élément capacitif, un cinquième élément capacitif connecté en parallèle du deuxième élément capacitif, un sixième élément capacitif connecté en parallèle du troisième élément capacitif, les quatrième, cinquième et sixième éléments capacitifs étant externes à la puce comprenant le circuit de mesure.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, sous la forme de blocs, un exemple d'un dispositif de mesure d'un courant ;
la figure 2 représente un exemple de mode de réalisation d'un circuit de mesure d'une dérivée selon un premier aspect ;
la figure 3 représente, sous la forme de blocs, un exemple de mode de réalisation d'un dispositif de mesure d'un courant comprenant un circuit de mesure d'une dérivée tel que décrit en relation avec la figure 2 ;
la figure 4 illustre un exemple de mode de réalisation d'un circuit de mesure d'une dérivée selon un deuxième aspect ;
la figure 5 illustre un exemple de mode de réalisation d'un circuit de mesure d'une dérivée selon un troisième aspect ;
la figure 6 illustre un exemple de mode de réalisation d'un circuit de mesure d'une dérivée selon un quatrième aspect ;
la figure 7 illustre un autre exemple de mode de réalisation d'un circuit de mesure d'une dérivée selon le quatrième aspect ;
la figure 8 illustre encore un autre exemple de mode de réalisation d'un circuit de mesure d'une dérivée selon le quatrième aspect ;
la figure 9 illustre encore un autre exemple de mode de réalisation d'un circuit de mesure selon le quatrième aspect ; et
la figure 10 illustre encore un autre exemple de mode de réalisation d'un circuit de mesure selon le quatrième aspect.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, bien que l'intérêt des modes de réalisation et variantes de réalisation du circuit de mesure de dérivée décrits ici soit illustré pour un dispositif de mesure d'un courant, ces modes de réalisation et variantes sont compatibles avec les applications et dispositifs usuels dans lesquels une dérivée d'une tension est calculée, en particulier, même lorsque cette tension n'est pas représentative d'un courant mais d'une autre grandeur physique comme par exemple la température.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

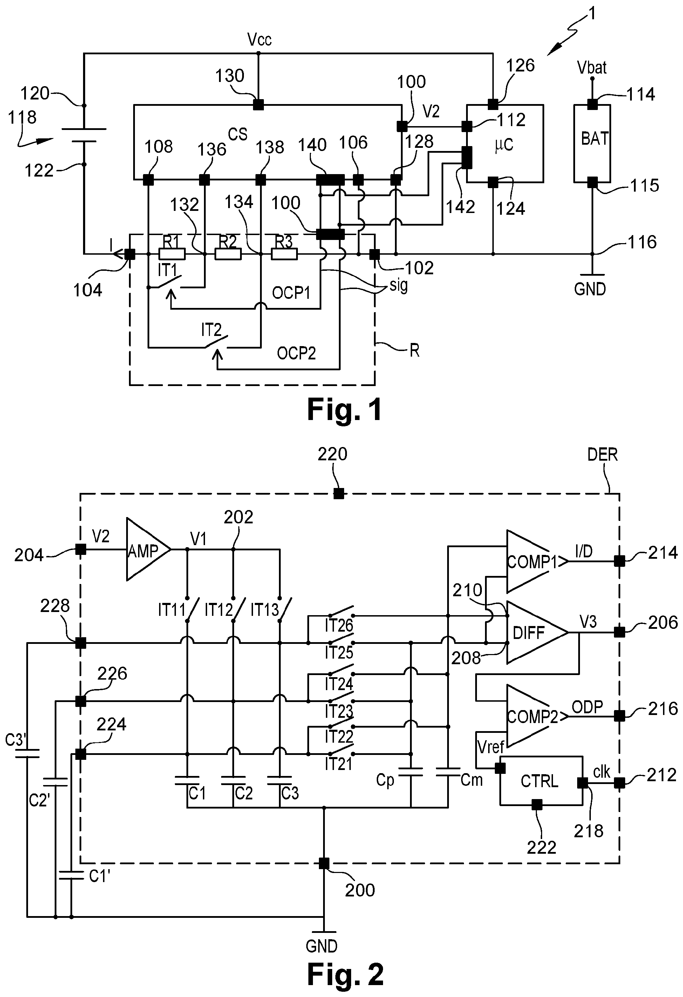

La figure 1 représente, sous la forme de bloc, un exemple d'un dispositif 1 de mesure d'un courant I.

Le dispositif 1 comprend un circuit CS et une résistance commandable R. La résistance R comprend une entrée 100 pour recevoir un signal de commande sig. Le signal sig commande la valeur de la résistance R. La résistance R comprend deux bornes 102 et 104 connectées à des entrées respectives 106 et 108 du circuit CS.

Le circuit CS est configuré pour fournir une tension V2, par exemple disponible sur une sortie 110 du circuit CS, indiquant la valeur du courant I circulant dans la résistance R.

A titre d'exemple, le dispositif 1 comprend un circuit de traitement µC, par exemple un microcontrôleur, configuré pour recevoir la tension V2, par exemple sur une entrée 112 du circuit µC.

A titre d'exemple, le dispositif 1 comprend en outre une batterie BAT ayant une borne supérieure 114 configuré pour fournir une tension Vbat, et une borne inférieure 115 connectée à un noeud 116 mis à un potentiel de référence GND, par exemple la masse.

A titre d'exemple, le dispositif 1 comprend en outre une source d'alimentation 118. La source d'alimentation 118 a une borne haute 120 délivrant une tension d'alimentation Vcc, et une borne basse 122.

A titre d'exemple, la résistance R est connectée entre le noeud 116 et la borne basse 122 de la source de tension 118.

A titre d'exemple, le circuit µC reçoit le potentiel GND, par exemple sur une entrée 124 du circuit µC connectée au noeud 116. A titre d'exemple, le circuit µC reçoit la tension Vcc, par exemple sur une entrée 126 du circuit µC.

A titre d'exemple, le circuit CS reçoit le potentiel GND, par exemple sur une entrée 128 du circuit CS connectée au noeud 116. A titre d'exemple, le circuit CS reçoit la tension Vcc, par exemple sur une entrée 130 du circuit CS.

La résistance R comprend N résistances Ri en série, avec i un indice entier allant de 1 à N et N un entier supérieur ou égal à 2, par exemple égal à trois en figure 1 (R1, R2 et R3) entre les bornes 102 et 104 de la résistance R. Les résistances Ri sont connectées par ordre d'indice i croissant à partir d'une des bornes 102 et 104, par exemple la borne 104 en figure 1. Par exemple, la résistance R1 est connectée entre la borne 104 et un noeud 132, la résistance R2 est connectée entre le noeud 132 et un noeud 134, et la résistance R3 est connectée entre le noeud 134 et la borne 102.

La résistance R comprend en outre N-1 interrupteurs ITi, avec i indice entier allant de 1 à N-1. Dans l'exemple de la figure 1, la résistance R comprend donc deux interrupteurs IT1 et IT2. Chaque interrupteur ITi est configuré pour court-circuiter, lorsqu'il est passant, les résistances Ri d'indice i allant de 1 à i. Ainsi, dans l'exemple de la figure 1, l'interrupteur IT1 est configuré pour court-circuiter, lorsqu'il est passant, la résistance R1 et l'interrupteur IT2 est configuré pour court-circuiter, lorsqu'il est passant, les résistances R1 et R2.

Le circuit CS est configuré pour comparer, pour chaque résistance Ri de la résistance R, une tension aux bornes de cette résistance Ri à au moins un seuil correspondant.

Par exemple, le circuit CS comprend, en plus de ses entrées 108 et 106 connectées aux bornes respectives 104 et 102, et pour chaque noeud 132, 134 de connexion de deux résistances internes R1 à R3 de la résistance R, une entrée correspondante connectée à ce noeud. Par exemple, le circuit CS comprend une entrée 136 connectée au noeud 132, et une entrée 138 connectée au noeud 134.

Le circuit CS est configuré pour adapter, ou commander, la valeur de la résistance commandable R en fonction de la valeur du courant I qui y circule. En effet, lorsque le courant I dans la résistance R augmente, par exemple lors d'un pic de courant transitoire ou surintensité ("Over Current" en anglais), si la valeur de la résistance R n'est pas modifiée, de préférence diminuée, la puissance dissipée dans la résistance R peut atteindre des valeurs conduisant à une destruction de la résistance R. Le circuit CS détermine comment commander chaque interrupteur ITi de la résistance R à partir des comparaisons des tensions aux bornes de chaque résistance Ri à au moins un seuil correspondant à cette résistance.

Par exemple, lorsque la tension aux bornes d'une résistance Ri atteint ou dépasse un premier seuil qui lui correspond, le circuit CS commande la résistance commandable pour que cette résistance soit court-circuitée, c'est à dire commande la fermeture de l'interrupteur ITi associé à cette résistance Ri, ce qui permet de réduire la valeur de la résistance R, et donc de la puissance qu'elle dissipe.

Par exemple, pour chaque interrupteur ITi, une fois que l'interrupteur ITi a été commuté à l'état passant, cet interrupteur commute à l'état bloqué si la tension aux bornes de la résistance Ri+1 passe en dessous d'un deuxième seuil associé à cette résistance.

En reprenant l'exemple de la figure 1, si le courant I augmente et que la tension aux bornes de la résistance R1 dépasse le premier seuil associé à cette résistance R1, le circuit CS commande la fermeture de l'interrupteur IT1. Si le courant I continue d'augmenter et que la tension aux bornes de la résistance R2 dépasse le premier seuil associé à cette résistance R2, le circuit CS commande la fermeture de l'interrupteur IT2. Si, alors que les deux interrupteurs IT1 et IT2 sont passants, le courant I décroit et que la tension aux bornes de la résistance R3 passe en-dessous du deuxième seuil associé à cette résistance R3, le circuit CS commande l'ouverture de l'interrupteur IT2. Si le courant I continue de décroître et que la tension aux bornes de la résistance R2 passe sous le deuxième seuil associé à cette résistance R2, le circuit CS commande la fermeture de l'interrupteur IT1.

Ainsi, dans l'exemple de fonctionnement ci-dessus, chaque résistance Ri à l'exception de la résistance R1 et de la résistance RN est associé à un premier seuil pour commander la fermeture de l'interrupteur ITi qui lui est associé, et à un deuxième seuil pour commander l'ouverture de l'interrupteur ITi-1. La résistance R1 est associé uniquement à un premier seuil pour commander la fermeture de l'interrupteur IT1 associé, la résistance RN n'étant associé qu'à un deuxième seuil pour commander l'ouverture de l'interrupteur RN-1.

Bien entendu, d'autres modes de commande de la résistance R pour adapter sa valeur de résistance en fonction du courant I qui y circule peuvent être envisagés, de même que le positionnement des interrupteurs permettant de court-circuiter des résistances internes de la résistance R peut être modifié.

Le circuit CS fournit un signal de commande sig à l'entrée de commande 100 de la résistance R, ce signal sig étant, par exemple, disponible sur une sortie 140 du circuit CS. Le signal sig est déterminée par les résultats des comparaisons des tensions aux bornes des résistances internes R1 à R3 de la résistance R à des seuils correspondants. Le signal sig commande les interrupteurs IT1, IT2 de la résistance R.

Dans cet exemple, le signal sig est constitué d'un signal OCP1 et d'un signal OCP2. Le signal OCP1 indique si la tension aux bornes de la résistance R1 est supérieure ou non au seuil qui lui correspond et commande l'interrupteur IT1, le signal OCP2 indiquant si la tension aux bornes de la résistance R2 est supérieure ou non au seuil qui lui correspond et commandant l'interrupteur IT2.

A titre d'exemple, le circuit µC reçoit le signal sig sur une entrée 142 du circuit µC. Par exemple, le signal sig comprend le signal OCP1 et le signal OCP2.

Le dispositif 1 comprend une protection contre les surintensités du courant I. Toutefois, les comparaisons des tensions aux bornes des résistances respectives R1 et R2 à des seuils correspondants sont mises en œuvre par des comparateurs ayant des temps de propagation non nuls. Il en résulte que, lors d'une augmentation du courant I, la diminution de la valeur de la résistance R peut intervenir trop tard, c'est-à-dire alors que le courant I a déjà atteint des valeurs pour lesquelles la puissance dissipée dans la résistance R est trop élevée et conduit à une destruction de la résistance R.

Afin d'éviter cela, il serait souhaitable que le dispositif 1 comprennent un circuit de mesure de la dérivée de la tension V2, donc de la dérivée du courant I, et qu'une protection contre les surintensités du courant I soit mise en œuvre lorsque cette dérivée atteint un seuil. Dit autrement, il serait souhaitable de mesurer la dérivée de la tension V2 pour diminuer la valeur de la résistance R avant que la tension aux bornes de la résistance R1 ou la tension aux bornes de la résistance R2 atteigne son seuil correspondant lorsque le courant I augmente rapidement, c'est-à-dire lorsque la dérivée de la tension V2 atteint un seuil.

### Premier aspect

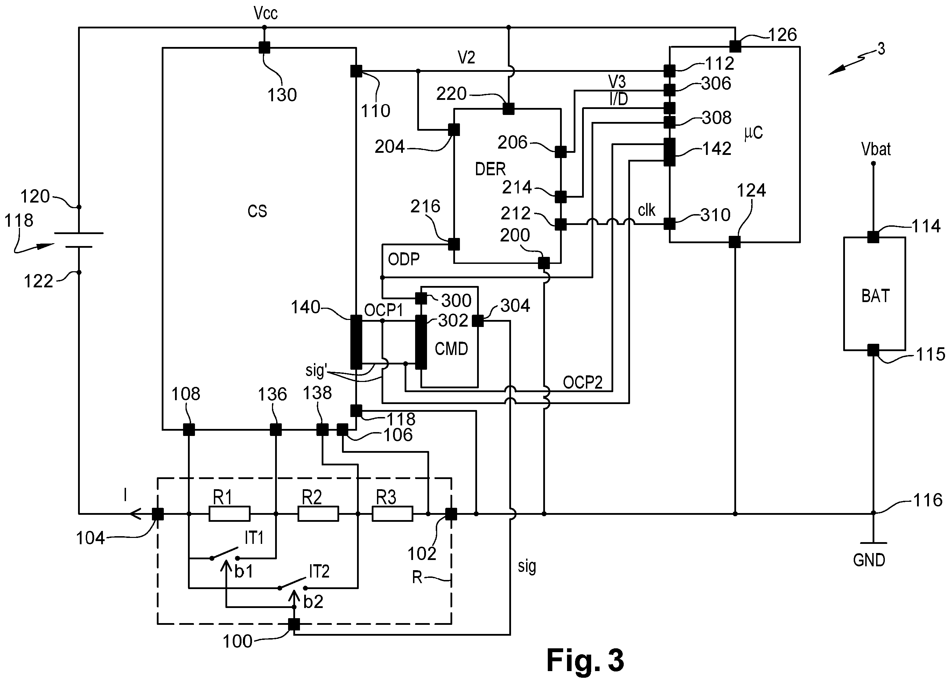

Un mode de réalisation d'un circuit de mesure d'une dérivée, par exemple d'une dérivée d'une tension représentative d'une grandeur physique, va maintenant être décrit en relation avec la figure 2. Bien que ce circuit puisse être utilisé dans un dispositif 3 similaire au dispositif 1, comme cela sera décrit en relation avec la figure 3, ce circuit de mesure permet de mesurer la dérivée de n'importe quelle tension représentative d'une grandeur physique, par exemple la température, cette dérivée mesurée n'étant pas nécessairement utilisée pour mettre en œuvre des protections contre des surintensités d'un courant.

La figure 2 représente un exemple de mode de réalisation d'un circuit DER de mesure d'une dérivée, par exemple d'une dérivée d'une tension représentative d'une grandeur physique selon le premier aspect.

Le circuit DER comprend trois éléments capacitifs C1, C2 et C3, de préférence identiques. Chacun des éléments C1, C2 et C3 a une première borne connectée à une entrée 200 du circuit DER, l'entrée 200 étant configurée pour recevoir un potentiel de référence GND.

Le circuit DER comprend en outre une entrée 220 configurée pour recevoir une tension d'alimentation du circuit DER et des circuits qu'il comprend.

Le circuit DER comprend en outre des premiers interrupteurs IT11, IT12 et IT13 couplant une deuxième borne de chacun des éléments respectifs C1, C2 et C3 à un noeud 202 du circuit DER.

Par exemple, l'interrupteur IT11 est connecté entre la deuxième borne de l'élément C1 et le noeud 202, l'interrupteur IT12 est connecté entre la deuxième borne de l'élément capacitif C2 et le noeud 202 et l'interrupteur IT13 est connecté entre la deuxième borne de l'élément C3 et le noeud 202.

Le noeud 202 est configuré pour recevoir une tension V1. La tension V1 est déterminée par une tension disponible sur une entrée 204 du circuit DER, le noeud 202 étant couplé à l'entrée 204. Dans cet exemple, le circuit DER reçoit la tension V2 décrite en relation avec la figure 1, ou, dit autrement, une tension V2 indiquant la valeur d'un courant.

Selon un mode de réalisation, le circuit DER comprend un circuit AMP couplant l'entrée 204 au noeud 202. Par exemple, le circuit AMP a une entrée connectée à l'entrée 204 pour recevoir la tension V2, et une sortie connectée au noeud 202 pour fournir la tension V1. Le circuit AMP est un circuit tampon ("buffer" en anglais), c'est-à-dire que la tension V1 est égale à la tension V2. Le circuit AMP permet de reporter des appels de charges des éléments capacitifs C1 à C3 sur l'alimentation du circuit DER plutôt que sur la tension V2.

En variante, le noeud 202 est connecté à l'entrée 204 et la tension V1 est égale à la tension V2.

Le circuit DER est configuré pour mesurer, ou calculer, la dérivée de la tension V2, c'est-à-dire pour fournir une tension V3 indiquant une valeur, à un facteur multiplicatif près, de la dérivée de la tension V2.

Pour cela, le circuit DER comprend un circuit DIFF. Le circuit DIFF comprend deux entrées 208 et 210 et une sortie configurée pour fournir la tension V3. La sortie du circuit DIFF est, par exemple, connectée à la sortie 206 du circuit DER. Le circuit DIFF est configuré pour que la tension V3 indique une valeur d'une différence de tension entre les entrées 210 et 208, par exemple une valeur de la tension sur l'entrée 208 moins la tension sur l'entrée 210. A titre d'exemple, le circuit DIFF comprend un amplificateur opérationnel, par exemple monté en amplificateur différentiel. A titre d'exemple, bien que cela ne soit pas illustré en figure 2, le circuit DIFF est connectée aux entrées 200 et 220 pour être alimenté.

En outre, le circuit DER comprend des deuxièmes interrupteurs IT21, IT22, IT23, IT24, IT25, IT26 couplant la deuxième borne de chacun des éléments C1 à C3 aux entrées 208 et 210 du circuit DIFF. Par exemple, chacun des éléments C1 à C3 a sa deuxième borne couplée à l'entrée 208 par un des deuxièmes interrupteurs et à l'entrée 210 par un autre des deuxièmes interrupteurs.

Par exemple, l'interrupteur IT21 est connecté entre la deuxième borne de l'élément C1 et l'entrée 208 du circuit DIFF, l'interrupteur IT22 est connecté entre la deuxième borne de l'élément C1 et l'entrée 210 du circuit DIFF, l'interrupteur IT23 est connecté entre la deuxième borne de l'élément C2 et l'entrée 208 du circuit DIFF, l'interrupteur IT24 est connecté entre la deuxième borne de l'élément C2 et l'entrée 210 du circuit DIFF, l'interrupteur IT25 est connecté entre la deuxième borne de l'élément C3 et l'entrée 208 du circuit DIFF et l'interrupteur IT26 est connecté entre la deuxième borne de l'élément C3 et l'entrée 210 du circuit DIFF.

Le circuit DER comprend un circuit CTRL. Le circuit CTRL est un circuit de commande des premiers interrupteurs (IT11 à IT13) et des deuxièmes interrupteurs (IT21 à IT26). A titre d'exemple, bien que cela ne soit pas illustré en figure 2, le circuit CTRL est connecté aux entrées 200 et 220 pour être alimenté.

Le circuit CTRL fournit les signaux de commande des premiers et deuxièmes interrupteurs, par exemple sur une sortie 222 du circuit CTRL. En figure 2, ces signaux de commande ne sont pas représentés pour ne pas surcharger la figure 2. A titre d'exemple, le circuit CTRL fournit un signal de commande comprenant un bit de commande distinct pour chacun des premiers et deuxièmes interrupteurs.

Le circuit CTRL est configuré pour mettre en œuvre des cycles successifs de fonctionnement, chaque cycle de fonctionnement correspondant à une succession de trois périodes d'un signal d'horloge interne du dispositif. Ainsi, chaque cycle de fonctionnement comprend une première période du signal d'horloge interne, suivie d'une deuxième période du signal d'horloge interne, elle-même suivie d'une troisième période du signal d'horloge interne. Les cycles de fonctionnement successifs ne se chevauchent pas, ou, dit autrement, aucune des trois périodes d'un cycle de fonctionnement ne correspond à l'une des trois périodes d'un autre cycle de fonctionnement. Le signal d'horloge interne est déterminé par un signal d'horloge clk. Le circuit CTRL reçoit le signal clk sur une entrée 218 du circuit CTRL. Le signal clk est reçu par le circuit DER sur une entrée 212 du circuit DER. Par exemple, le circuit CTRL a son entrée 218 connectée à l'entrée 212.

Selon un mode de réalisation, le signal d'horloge interne est identique au signal d'horloge clk.

A titre de variante, le signal d'horloge interne est obtenu à partir du signal clk, par exemple par une division de la fréquence du signal clk.

De préférence, les signaux de commande des premiers et deuxièmes interrupteurs sont synchronisés avec le signal d'horloge interne, par exemple avec les fronts montants et descendants du signal d'horloge interne.

Le circuit CTRL commande les premiers et deuxièmes interrupteurs pour que, à chaque première période d'un cycle de fonctionnement, la tension V1 soit mémorisée sur l'élément capacitif C1, et, en outre, les entrées 208 et 210 du circuit DIFF reçoivent les tensions des éléments respectifs C3 et C2.

Plus particulièrement, à chaque première période, le circuit CTRL commande les premiers interrupteurs pour que la tension V1 soit mémorisée entre les bornes de l'élément capacitif C1, et les deuxièmes interrupteurs pour que la deuxième borne de l'élément C3 soit couplée à l'entrée 208 du circuit DIFF et que la deuxième borne de l'élément C2 soit couplée à l'entrée 210.

Dit autrement, à chaque première période, le circuit CTRL maintient ouverts les interrupteurs IT12 et IT13 et commute, pendant tout ou partie de cette première période, par exemple pendant la première moitié de cette première période, l'interrupteur IT11 à l'état passant. Pendant que l'interrupteur IT11 est passant, l'élément capacitif C1 se charge (ou se décharge) de sorte que la tension sur la deuxième borne de l'élément C1 devient égale à la tension V1. Lorsque l'interrupteur IT11 est de nouveau commuté à l'état bloqué, cela mémorise, sur l'élément capacitif C1, la tension présente entre ses bornes, cette tension étant égale à la tension V1 au moment de la commutation à l'état bloqué de l'interrupteur IT11. En outre, à chaque première période, le circuit CTRL commute, pendant tout ou partie de la première période, par exemple pendant la première moitié de la première période, les interrupteurs IT24 et IT25 à l'état passant alors que les autres deuxièmes interrupteurs sont maintenus ouverts. De cette manière, la deuxième borne de l'élément C3 est couplée à l'entrée 208 du circuit DIFF par l'interrupteur IT25 à l'état passant, l'entrée 208 recevant donc la tension aux bornes de l'élément C3, et la deuxième borne de l'élément C2 est couplée à l'entrée 210 du circuit DIFF par l'interrupteur IT24 à l'état passant, l'entrée 210 recevant donc la tension aux bornes de l'élément C2.

La fenêtre temporelle pendant laquelle, pour chaque première période, le circuit CTRL couple avec les interrupteurs IT24 et IT25 les éléments C2 et C3 aux entrées respectives 210 et 208 peut débuter pendant la troisième période précédant cette première période. Par exemple, cette fenêtre temporelle peut commencer à la moitié de la troisième période précédente et se terminer à la moitié de la première période courante.

Le circuit CTRL commande les premiers et deuxièmes interrupteurs pour que, à chaque deuxième période d'un cycle de fonctionnement, la tension V1 soit mémorisée sur l'élément capacitif C2, et, en outre, les entrées 208 et 210 du circuit DIFF reçoivent les tensions des éléments respectifs C1 et C3.

Plus particulièrement, à chaque deuxième période, le circuit CTRL commande les premiers interrupteurs pour que la tension V1 soit mémorisée entre les bornes de l'élément capacitif C2, et les deuxièmes interrupteurs pour que la deuxième borne de l'élément C1 soit couplée à l'entrée 208 du circuit DIFF et que la deuxième borne de l'élément C3 soit couplée à l'entrée 210.

Dit autrement, à chaque deuxième période, le circuit CTRL maintient ouverts les interrupteurs IT11 et IT13 et commute, pendant tout ou partie de cette deuxième période, par exemple pendant la première moitié de cette deuxième période, l'interrupteur IT12 à l'état passant. Pendant que l'interrupteur IT12 est passant, l'élément capacitif C2 se charge (ou se décharge) de sorte que la tension sur la deuxième borne de l'élément C2 devient égale à la tension V1. Lorsque l'interrupteur IT12 est de nouveau commuté à l'état bloqué, cela mémorise, sur l'élément capacitif C2, la tension présente entre ses bornes, cette tension étant égale à la tension V1 au moment de la commutation à l'état bloqué de l'interrupteur IT12. En outre, à chaque deuxième période, le circuit CTRL commute, pendant tout ou partie de la deuxième période, par exemple pendant la première moitié de la deuxième période, les interrupteurs IT21 et IT26 à l'état passant alors que les autres deuxièmes interrupteurs sont maintenus ouverts. De cette manière, la deuxième borne de l'élément C1 est couplée à l'entrée 208 du circuit DIFF par l'interrupteur IT25 à l'état passant, l'entrée 208 recevant donc la tension aux bornes de l'élément C1, et la deuxième borne de l'élément C3 est couplée à l'entrée 210 du circuit DIFF par l'interrupteur IT24 à l'état passant, l'entrée 210 recevant donc la tension aux bornes de l'élément C3.

La fenêtre temporelle pendant laquelle, pour chaque deuxième période, le circuit CTRL couple avec les interrupteurs IT21 et IT26 les éléments C1 et C3 aux entrées respectives 208 et 210 peut débuter pendant la première période précédant cette deuxième période. Par exemple, cette fenêtre temporelle peut commencer à la moitié de la première période précédente et se terminer à la moitié de la deuxième période courante.

Le circuit CTRL commande les premiers et deuxièmes interrupteurs pour que, à chaque troisième période d'un cycle de fonctionnement, la tension V3 soit mémorisée sur l'élément capacitif C3, et, en outre, les entrées 208 et 210 du circuit DIFF reçoivent les tensions des éléments respectifs C2 et C1.

Plus particulièrement, à chaque troisième période, le circuit CTRL commande les premiers interrupteurs pour que la tension V1 soit mémorisée entre les bornes de l'élément capacitif C3, et les deuxièmes interrupteurs pour que la deuxième borne de l'élément C2 soit couplée à l'entrée 208 du circuit DIFF et que la deuxième borne de l'élément C1 soit couplée à l'entrée 210.

Dit autrement, à chaque troisième période, le circuit CTRL maintient ouverts les interrupteurs IT11 et IT12 et commute, pendant tout ou partie de cette troisième période, par exemple pendant la première moitié de cette troisième période, l'interrupteur IT13 à l'état passant. Pendant que l'interrupteur IT13 est passant, l'élément capacitif C3 se charge (ou se décharge) de sorte que la tension sur la deuxième borne de l'élément capacitif C3 devient égale à la tension V1. Lorsque l'interrupteur IT13 est de nouveau commuté à l'état bloqué, cela mémorise, sur l'élément capacitif C3, la tension présente entre ses bornes, cette tension étant égale à la tension V1 au moment de la commutation à l'état bloqué de l'interrupteur IT13. En outre, à chaque troisième période, le circuit CTRL commute, pendant tout ou partie de la troisième période, par exemple pendant la première moitié de la troisième période, les interrupteurs IT22 et IT23 à l'état passant alors que les autres deuxièmes interrupteurs sont maintenus ouverts. De cette manière, la deuxième borne de l'élément C2 est couplée à l'entrée 208 du circuit DIFF par l'interrupteur IT23 à l'état passant, l'entrée 208 recevant donc la tension aux bornes de l'élément C2, et la deuxième borne de l'élément C1 est couplée à l'entrée 210 du circuit DIFF par l'interrupteur IT22 à l'état passant, l'entrée 210 recevant donc la tension aux bornes de l'élément C1.

La fenêtre temporelle pendant laquelle, pour chaque troisième période, le circuit CTRL couple avec les interrupteurs IT22 et IT23 les éléments C1 et C2 aux entrées respectives 210 et 208 peut débuter pendant la deuxième période précédant cette troisième période. Par exemple, cette fenêtre temporelle peut commencer à la moitié de la deuxième période précédente et se terminer à la moitié de la troisième période courante.

Selon un mode de réalisation, chaque mémorisation de la tension V1 sur un élément capacitif C1, C2, C3 a une même durée, c'est-à-dire que la fenêtre temporelle pendant laquelle le premier interrupteur IT11, IT12, IT13 correspondant est passant pour mettre en œuvre cette mémorisation à la même durée pour chacune des premières, deuxièmes et troisièmes périodes du signal d'horloge interne. Cette durée est, par exemple, inférieure ou égale à la durée d'une période du signal d'horloge interne, par exemple égale à une demi-période du signal d'horloge interne.

En outre, la durée Ton séparant deux mémorisations successives, c'est-à-dire la durée Ton séparant la fin de deux mémorisations successives, ou, dit autrement, la durée Ton entre la mise à l'état bloqué de l'interrupteur IT11 et celle de l'interrupteur IT12, entre la mise à l'état bloqué de l'interrupteur IT12 et celle de l'interrupteur IT13, et entre la mise à l'état bloqué de l'interrupteur IT13 et celle de l'interrupteur IT11, est constante et est égale à une période du signal d'horloge d'interne.

Pour illustrer le fonctionnement du circuit DER décrit ci-dessus, on considère un premier cycle et un deuxième cycle de fonctionnement successifs dans lesquels :
la tension V1 est mémorisée sur l'élément C1 à un instant t0 de la première période du premier cycle, d'où il résulte que, à la fin de la mémorisation, une tension Vc1 aux bornes de l'élément C1 est égale à V1(t0) (la tension V1 à l'instant t0) ;
la tension V1 est mémorisée sur l'élément C2 à un instant t0 + Ton de la deuxième période du premier cycle, d'où il résulte que, à la fin de la mémorisation, une tension Vc2 aux bornes de l'élément C2 est égale à V1(t0+Ton) ;
la tension V1 est mémorisée sur l'élément C3 à un instant t0 + 2.Ton de la troisième période du premier cycle, d'où il résulte que, à la fin de la mémorisation, une tension Vc3 aux bornes de l'élément C3 est égale à V1(t0+2.Ton) ;
la tension V1 est mémorisée sur l'élément C1 à un instant t0 + 3.Ton de la première période du deuxième cycle, d'où il résulte que, à la fin de la mémorisation, la tension Vc1 aux bornes de l'élément C1 est égale à V1(t0+3.Ton) ;
la tension V1 est mémorisée sur l'élément C2 à un instant t0 + 4.Ton de la deuxième période du deuxième cycle, d'où il résulte que, à la fin de la mémorisation, la tension Vc2 aux bornes de l'élément C2 est égale à V1(t0+4.Ton) ; et
la tension V1 est mémorisée sur l'élément C3 à un instant t0 + 5.Ton de la troisième période du deuxième cycle, d'où il résulte que, à la fin de la mémorisation, une tension Vc3 aux bornes de l'élément C3 est égale à V1(t0+5.Ton).

Ainsi, dans cet exemple, lors de la première période du deuxième cycle, lorsque les éléments C3 et C2 sont couplés aux entrées du circuit DIFF, la tension V3 est alors à une valeur déterminée par la différence entre la tension Vc3 aux bornes de l'élément C3 qui est égale à V1(t0+2.Ton) et la tension Vc2 aux bornes de l'élément C2 qui est égale à V1(t0+Ton), la tension V3 étant alors par exemple égale à A. (V1(t0+2.Ton)-V1(t0+Ton)), donc à A. (V1(t1+Ton)-V1(t1)), avec t1 égal à t0+Ton et A un facteur multiplicatif déterminé au moins en partie par le gain du circuit DIFF. Comme la tension V1 est égale à la tension V2, il en résulte que la tension V3 est égale à K. (V2(t1+Ton)-V2(t1))/Ton, donc à K fois la dérivée de la tension V2 à l'instant t1, avec K égal à A. Ton.

De manière similaire, lors de la deuxième période du deuxième cycle, lorsque les éléments C1 et C3 sont couplés aux entrées du circuit DIFF, la tension V3 est alors à une valeur déterminée par la différence entre la tension Vc1 aux bornes de l'élément C3 qui est égale à V1(t0+3.Ton) et la tension Vc2 aux bornes de l'élément C2 qui est égale à Vl(t0+2.Ton), la tension V3 étant alors par exemple égale à A. (V1(t0+3.Ton)-V1(t0+2.Ton)), donc à A.(V1(t2+Ton)-V1(t2)), avec t2 égal à t0+2. Ton. Comme précédemment, la tension V3 est égale à K.(V2(t2+Ton)-V2(t2))/Ton, donc à K fois la dérivée de la tension V2 à l'instant t2.

En outre, lors de la troisième période du deuxième cycle de fonctionnement, lorsque les éléments C1 et C2 sont couplés aux entrées du circuit DIFF, la tension V3 est alors à une valeur déterminée par la différence entre la tension Vc2 aux bornes de l'élément C2 qui est égale à V1(t0+4.Ton) et la tension Vc1 aux bornes de l'élément C3 qui est égale à V1(t0+3.Ton), la tension V3 étant alors par exemple égale à A. (V1(t0+4.Ton)-V1(t0+3.Ton)), donc à A.(V1(t3+Ton)-V1(t3)), avec t3 égal à t0+3.Ton. Comme précédemment, la tension V3 est égale à K. (V2(t3+Ton)-V2(t3))/Ton, donc à K fois la dérivée de la tension V2 à l'instant t3.

Le circuit DER ci-dessus permet donc de fournir, à chaque période du signal d'horloge, une tension V3 indiquant la valeur de la dérivée de la tension V2, la valeur de cette tension V3 étant mise à jour à chaque période du signal d'horloge interne. Plus particulièrement, le circuit DER ci-dessus permet, à chaque période du signal d'horloge interne d'échantillonner une valeur de la tension V1 sur l'un des éléments capacitifs C1 à C3, et, dans le même cycle, de fournir une valeur de la dérivée de la tension V1 en utilisant les valeurs de tension V1 échantillonnées sur les deux autres éléments capacitifs. Ainsi, il n'y a pas de cycle où aucune valeur de la tension V1 n'est échantillonnée, ni de cycle où aucune valeur de dérivée n'est fournie.

De manière avantageuse, le circuit DER ne comprend pas d'amplificateur opérationnel monté en dérivateur, ni de convertisseur analogique numérique, ni de microprocesseur.

Selon un mode de réalisation, le circuit CTRL est configuré pour modifier la fréquence du signal d'horloge interne, donc la durée Ton. Par exemple, lorsque le circuit DER est dans un mode de fonctionnement à basse consommation, la fréquence du signal d'horloge interne peut être réduite pour diminuer la consommation. A titre d'exemple complémentaire ou alternatif, la fréquence du signal d'horloge interne peut être choisie en fonction de l'application dans laquelle est mis en œuvre le circuit DER.

En pratique, la valeur des éléments capacitifs C1 à C3 est déterminée par la fréquence du signal d'horloge interne, de sorte que la tension aux bornes de chacun de ces éléments n'évolue pas, ou alors de manière négligeable par rapport à une précision de mesure visée, entre un instant où la tension V1 est mémorisée sur cet élément capacitif et les instants où cette tension mémorisée est fournie en entrée du circuit DIFF. Par exemple, plus la fréquence est faible, plus la valeur de capacité des éléments C1 à C3 est grande.

Toutefois, cette fréquence peut différer d'une application à une autre dans lesquelles le circuit DER est mis en œuvre, et il est alors souhaitable de ne pas dimensionner les valeurs de capacité des éléments différemment pour chacune de ces applications. Cela est en particulier le cas lorsque le circuit DER fait partie d'une puce de circuit intégré.

En outre, lorsque le circuit DER est un circuit intégré d'une puce de circuit intégré, il est souhaitable d'avoir des valeurs de capacité faibles pour les éléments C1 à C3, de sorte à limiter la surface occupée par le circuit DER.

Ainsi, selon un mode de réalisation, lorsque le circuit DER est un circuit intégré d'une puce de circuit intégré, un dispositif comprenant le circuit DER comprend en outre, comme cela est illustré en figure 2, des éléments capacitifs C1', C2', C3' connectés en parallèle des éléments capacitifs respectifs C1, C2 et C3, et ces éléments C1', C2' et C3' sont disposés à l'extérieur de la puce comprenant le circuit DER. De cette façon, la valeur de capacité entre l'interrupteur IT11 et le noeud 200, entre l'interrupteur IT12 et le noeud 200 et entre l'interrupteur IT13 et le noeud 200 peut être augmentée et/ou ajustée sans modifier la valeur de capacité des éléments C1 à C3. De préférence, les éléments C1' à C3' ont tous une même valeur de capacité.

A titre d'exemple, l'élément C1' a une première borne connectée à l'entrée 200 du circuit DER qui est elle-même connectée à la première borne de l'élément C1, et une deuxième borne connectée à une entrée 224 du circuit DER qui est elle-même connectée à la deuxième borne de l'élément C1. A titre d'exemple, l'élément C2' a une première borne connectée à l'entrée 200 du circuit DER qui est elle-même connectée à la première borne de l'élément C2, et une deuxième borne connectée à une entrée 226 du circuit DER qui est elle-même connectée à la deuxième borne de l'élément C2. A titre d'exemple, l'élément C3' a une première borne connectée à l'entrée 200 du circuit DER qui est elle-même connectée à la première borne de l'élément C3, et une deuxième borne connectée à une entrée 228 du circuit DER qui est elle-même connectée à la deuxième borne de l'élément C3.

Selon un mode de réalisation, le circuit CTRL est configuré pour commander le gain du circuit DIFF, c'est-à-dire la valeur du coefficient A décrit ci-dessus.

Selon un mode de réalisation, comme cela est illustré en figure 2, le circuit DER comprend un élément capacitif Cp connecté entre l'entrée 208 du circuit DIFF et l'entrée 200 du circuit DER, et un élément capacitif Cm connecté entre l'entrée 210 du circuit DIFF et l'entrée 200 du circuit DER. Ces éléments Cp et Cm ont la même valeur de capacité. Ces éléments Cp et Cm sont des éléments capacitifs de lissage (ou filtrage passe-bas). Dit autrement, les éléments Cp et Cm permettent d'estomper l'effets des injections de charges sur les entrées du circuit DER lors des commutations des interrupteurs IT21 à IT26.

Dans une variante de réalisation, ces éléments Cp et Cm sont toutefois omis.

Selon un mode de réalisation, il peut être souhaitable que le circuit DER indique lorsque la dérivée de la tension V2 dépasse un seuil Th, par exemple lorsque le circuit DER est destiné à une utilisation dans un dispositif du type du dispositif 1 décrit en relation avec la figure 1. Dans ce cas, le circuit DER comprend un circuit, ou comparateur, COMP2, par exemple un amplificateur opérationnel monté, ou configuré, en comparateur de tension. Le circuit COMP2 est configuré pour comparer la tension V3 de sortie du circuit DIFF à une tension Vref, la tension V3 indiquant une valeur de la dérivée de la tension V2 et la tension Vref indiquant une valeur du seuil Th, et pour fournir un signal ODP indiquant le résultat de cette comparaison. Le signal ODP indiquant le résultat de la comparaison de la tension V3 à la tension Vref, c'est-à-dire de la comparaison de la dérivée de la tension V2 au seuil Vth, est fourni par le circuit COMP2, par exemple par une sortie du circuit COMP2, à une sortie 216 du circuit DER.

A titre d'exemple, le circuit COMP2 a une entrée connectée à la sortie du circuit DIFF pour recevoir la tension V3, et une entrée configurée pour recevoir la tension Vref, et sa sortie connectée à la sortie 216 du circuit DER.

A titre d'exemple, la tension Vref est fournie par le circuit CTRL.

A titre d'exemple, lorsque le circuit CTRL est configuré pour modifier la fréquence du signal d'horloge interne (donc la durée Ton) et/ou le gain du circuit DIFF, pour une valeur de seuil Th donnée, le circuit CTRL est configuré pour adapter la valeur de la tension Vref pour tenir compte des variations de la fréquence du signal d'horloge interne et/ou du gain du circuit DIFF.

Selon un mode de réalisation, il est souhaitable que le circuit DER fournisse également une indication du sens de variation de la valeur de la tension V2, c'est-à-dire du signe de la dérivée. Dans ce cas, le circuit DER comprend un circuit, ou comparateur, COMP1, par exemple un amplificateur opérationnel monté, ou configuré, en comparateur de tension. Le circuit COMP1 est configuré pour comparer entre elles les tensions appliquées aux entrées du circuit DIFF, et pour fournir un signal I/D indiquant le résultat de cette comparaison. Le signal I/D indiquant le résultat de la comparaison est fourni par le circuit COMP1, par exemple par une sortie du circuit COMP1, à une sortie 214 du circuit DER.

A titre d'exemple, le circuit COMP1 a une entrée connectée à l'entrée 208 du circuit DIFF, une entrée connectée à l'entrée 210 du circuit DIFF, et sa sortie connectée à la sortie 214 du circuit DER.

A titre d'exemple, bien que cela ne soit pas illustré en figure 2, un circuit tampon analogique peut être prévu entre chaque interrupteur IT21 à IT26 et l'entrée 210 et 208 correspondante du circuit DIFF. Plus particulièrement, un circuit tampon analogique peut être prévu entre un noeud de connexion des interrupteurs IT21, IT23 et IT25 entre eux et l'entrée 208 du circuit DIFF et/ou un circuit tampon analogique peut être prévu entre un noeud de connexion des interrupteurs IT22, IT24 et IT26 entre eux et l'entrée 210 du circuit DIFF.

La figure 3 représente, sous la forme de blocs, un exemple de mode de réalisation d'un dispositif de mesure d'un courant comprenant un circuit DER de mesure d'une dérivée tel que décrit en relation avec la figure 2. Le dispositif 3 est similaire au dispositif 1 et seules les différences entre ces deux dispositifs sont ici détaillées.

Le dispositif 3 de la figure 3 comprend, comme le dispositif 1 de la figure 1, le circuit CS et la résistance commandable R. Toutefois, dans cet exemple, le signal sig de commande de la résistance R n'est pas fourni par le circuit CS. En revanche, la sortie 140 du circuit CS fournit un signal sig' déterminé par les résultats des comparaisons des tensions aux bornes des résistances internes R1 à R3 de la résistance R à des seuils correspondants.

Plus particulièrement, le signal sig' est, par exemple, identique au signal sig décrit en relation avec la figure 1. Ainsi, le signal sig' est, par exemple constitué d'un signal OCP1 et d'un signal OCP2. Le signal OCP1 commande l'interrupteur IT1, le signal OCP2 commandant l'interrupteur IT2.

A titre d'exemple, le dispositif 3 comprend en outre, comme le dispositif 1, la source d'alimentation 118.

A titre d'exemple, le dispositif 3 comprend, comme le dispositif 1, la batterie BAT.

A titre d'exemple, le dispositif 3 comprend, comme le dispositif 1, le circuit de traitement µC, ce circuit µC étant par exemple un microprocesseur. A titre d'exemple, le circuit µC reçoit le signal sig' sur son entrée 142.

Le dispositif 3 comprend en outre le circuit DER et un circuit de commande des interrupteurs CMD.

Le circuit DER est, de préférence, mis en œuvre sur une puce de circuit intégré.

Le circuit DER a son entrée 220 qui est par exemple connectée à la borne 120 de la source de tension 118 pour recevoir la tension Vcc, et son entrée 200 qui est connecté au noeud 116 pour recevoir le potentiel de référence GND.

Le circuit DER a son entrée 204 connectée à la sortie 110 du circuit CS pour recevoir la tension V2.

Le circuit DER reçoit le signal clk sur son entrée 212, ce signal clk étant, par exemple, fourni par le circuit µC, par exemple par une sortie 310 du circuit µC.

A titre d'exemple, la tension V3 indiquant la valeur de la dérivée de la tension V2, donc la valeur de la dérivée du courant I, est fournie par le circuit DER au circuit µC. Par exemple, le circuit µC a une entrée 306 couplée, de préférence connectée, à la sortie 206 du circuit DER pour recevoir la tension V3.

Le signal CMD est configuré pour fournir le signal sig de commande de la résistance R, ce signal sig étant ici différent de celui décrit en relation avec la figure 1. En effet, dans ce mode de réalisation, le signal sig est au moins en partie déterminé par la comparaison de la tension V3 au seuil Th qui est mise en œuvre dans le circuit DER, et, donc, plus largement, le signal sig est au moins en partie déterminé par la tension V3 de la sortie 206 du circuit DER.

Dans ce mode de réalisation, le circuit DER comprend le circuit COMP2 (non représenté en figure 3) et la sortie 216. La sortie 216 du circuit DER est couplée, de préférence connectée, au circuit CMD, par exemple à une entrée 300 du circuit CMD. A titre d'exemple, le signal ODP est également fourni au circuit µC, par exemple à une entrée 308 du circuit µC.

Plus particulièrement, le circuit CMD reçoit également, du circuit CS, le signal sig' indiquant la valeur de consigne de la résistance R en fonction de l'évolution du courant I dans cette dernière, par exemple sur une entrée 302 du circuit CMD.

Le signal sig est alors déterminé à partir du signal ODP et du signal sig', c'est-à-dire à partir du signal ODP et des signaux OCP1 et OCP2 dans cet exemple. A titre d'exemple, le signal sig est un signal sur un nombre de bits égal au nombre d'interrupteurs de la résistance R, par exemple deux bits b1 et b2 dans cet exemple, chaque bit du signal sig commandant un interrupteur différent de la résistance R. Par exemple, le bit b1 commande l'interrupteur IT1 et le bit b2 commande l'interrupteur IT2.

Le circuit CMD reçoit donc non seulement le signal sig' lui indiquant quelle valeur la résistance R devrait prendre au vu du courant I qui y circule, mais aussi le signal ODP indiquant lorsque la dérivée de la tension V2 dépasse le seuil Th.

Ainsi, le circuit CMD fournit un signal sig de commande de la résistance qui, par exemple, force la résistance à une valeur plus faible que celle indiquée par le signal sig' lorsque la dérivée de la tension V2 dépasse le seuil Th, c'est à dire lorsque le courant I varie rapidement ce qui pourrait conduire à une destruction de la résistance R avant que le signal sig n'indique au circuit CMD que la valeur de la résistance R doit être réduite.

Par exemple, le signal sig indique, par son bit b1, que l'interrupteur IT1 doit être commuté à l'état passant si le signal OCP1 indique que cet interrupteur IT1 doit être commuté à l'état passant et/ou si le signal ODP indique que la dérivée de la tension V2 a dépassé le seuil, le signal sig indiquant en outre, par son bit b2, que l'interrupteur IT2 doit être commuté à l'état passant si le signal OCP2 indique que cet interrupteur IT2 doit être commuté à l'état passant et/ou si le signal ODP indique que la dérivée de la tension V2 a dépassé le seuil.

A titre d'exemple, le circuit DER comprend la sortie 214 et le circuit COMP1 (non représenté en figure 3) qui fournit le signal I/D à cette sortie 214. A titre d'exemple, ce signal I/D est fourni au circuit µC. Par exemple, le circuit µC a une entrée 312 couplée, de préférence connectée, à la sortie 214 du circuit DER.

Bien que dans cet exemple le dispositif 3 ne comprennent pas les éléments capacitifs C1', C2' et C3', cela peut être le cas dans d'autres exemples non illustrés.

Dans le dispositif 3 ci-dessus, le circuit DER et le circuit CMD sont représentés comme des circuits externes aux circuit CS. Toutefois, dans d'autres exemples non illustrés, les circuits CS, DER et CMD peuvent être mis en œuvre dans un même circuit global, par exemple un circuit d'une puce de circuit intégré. Dans ce cas, la connexion des circuits CMD, DER et CS à l'intérieur de ce circuit global est similaire à ce qui a été décrit précédemment. En outre, chaque entrée, respectivement sortie, des circuits CMD, CS et DER couplée ou connectée à un élément extérieur à ce circuit global constitue alors également une entrée, respectivement une sortie, du circuit global, étant entendu que lorsque au moins deux des circuits CMD, DER et CS ont des entrées, respectivement des sorties, couplées ou connectées à un même élément extérieur au circuit global, ce dernier ne comprend qu'une entrée, respectivement sortie, correspondante. A titre d'exemple, en reprenant l'exemple de dispositif 3 tel qu'il est illustré en figure 3, et en considérant que les circuits CMD, DER et CS font partie d'un même circuit global, ce circuit global aura des entrées correspondant aux entrées 106, 108, 136, 118 et 130 du circuit CS et à l'entrée 212 du circuit DER, et des sorties correspondant aux sorties 206, 214, 216 du circuit DER, à la sortie 304 du circuit CMD, et aux sorties 110 et 140 du circuit CS.

Dans l'exemple de dispositif 3 décrit ci-dessus, la résistance R comprend trois résistances en série. Toutefois, la personne du métier sera en mesure d'adapter la description faite ci-dessus au cas où la résistance R comprend uniquement deux résistances en série, ou, à l'inverse, quatre résistances en série ou plus.

### Deuxième aspect

Dans les modes de réalisation du premier aspect décrit ci-dessus, le circuit DER comprend M éléments capacitifs, avec M entier et égal à 3 dans le premier aspect. Le circuit DER met en œuvre des cycles de fonctionnement successifs comprenant chacun M périodes successives d'un signal d'horloge interne, et, à chaque période d'un cycle, le circuit DER commande une mémorisation d'une tension d'entrée sur un des M éléments capacitifs et, en outre, met en œuvre une différence entre une première tension mémorisée sur un des M éléments capacitifs à un premier instant et une deuxième tension représentative de la tension d'entrée à un deuxième instant postérieur au premier instant et séparé du premier instant par une durée constante, par exemple égal à une période de l'horloge interne.

Plus particulièrement, dans le premier aspect, celui des M éléments capacitifs sur lequel s'effectue la mémorisation est modifié à chaque période d'un cycle donné et est différent pour chacune des M périodes de ce cycle.

En outre, dans le premier aspect, à chaque période d'un cycle donné, la première tension est la tension aux bornes d'un des M éléments capacitifs autre que celui sur lequel s'effectue la mémorisation pour cette période, et la deuxième tension représentative de la tension d'entrée est la tension aux bornes d'un des M éléments capacitifs autre que celui sur lequel s'effectue la mémorisation pour cette période et que celui aux bornes duquel est disponible la première tension pour cette période.

Dans le deuxième aspect, comme dans le premier aspect, le circuit DER comprend M éléments capacitifs, avec M entier positif et non nul. Le circuit DER met en œuvre des cycles de fonctionnement successifs comprenant chacun M périodes successives d'un signal d'horloge interne, et, à chaque période d'un cycle, le circuit DER commande une mémorisation d'une tension d'entrée sur un des M éléments capacitifs et, en outre, met en œuvre une différence entre une première tension mémorisée sur un des M éléments capacitifs à un premier instant et une deuxième tension représentative de la tension d'entrée à un deuxième instant postérieur au premier instant et séparé du premier instant par une durée constante, par exemple égal à une période de l'horloge interne.

Toutefois, par rapport au premier aspect, dans le deuxième aspect, M est égal à 2.

Plus particulièrement, dans le deuxième aspect, celui des M éléments capacitifs sur lequel s'effectue la mémorisation est modifié à chaque période d'un cycle donné et est différent pour chacune des M périodes de ce cycle.

En outre, dans le deuxième aspect, à chaque période d'un cycle donné, la première tension est la tension aux bornes de celui des M éléments capacitifs sur lequel la tension d'entrée a été mémorisée à cette période, et la deuxième tension représentative de la tension d'entrée est la tension aux bornes d'un des M éléments capacitifs autre que celui sur lequel s'effectue la mémorisation pour cette période.

Des modes de réalisation détaillés d'un circuit DER de calcul de dérivée selon le deuxième aspect vont maintenant être décrits.

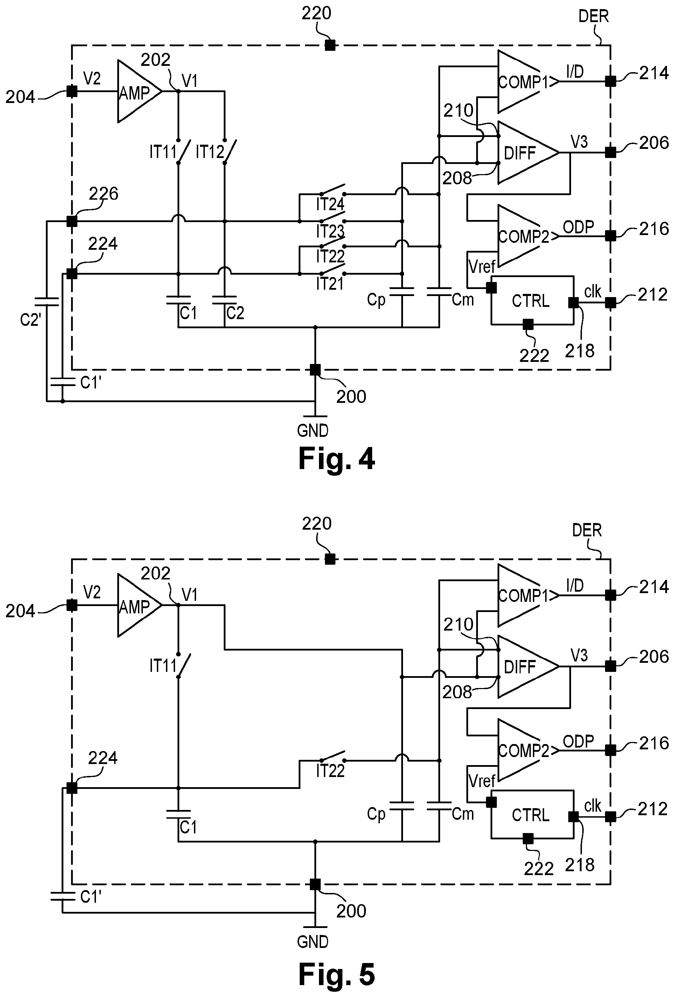

La figure 4 illustre un exemple de mode de réalisation du circuit DER de mesure d'une dérivée, par exemple d'une dérivée d'une tension représentative d'une grandeur physique, selon le deuxième aspect.

Le circuit DER selon le deuxième aspect comprend de nombreux éléments en commun avec le circuit DER selon le premier aspect, et seules les différences entre ces deux circuits sont ici mises en exergue. Ainsi, sauf indication contraire, tout ce qui a été décrit pour le circuit DER selon le premier aspect s'applique au circuit DER selon le deuxième aspect.

En particulier, par rapport au circuit DER selon le premier aspect, le circuit DER selon le deuxième aspect ne comprend que M=2 éléments capacitifs pour mémoriser la tension V1 représentative de (ou déterminée par) la tension V2 pour laquelle le circuit DER calcule la dérivée. Ainsi, par rapport au circuit DER selon le premier aspect, le circuit DER selon le deuxième aspect ne comprend pas l'élément capacitif C3.

Le circuit DER selon le deuxième aspect ne comprend donc pas non plus tous les autres éléments du circuit DER selon le premier aspect qui sont liés à l'élément capacitif C3. Ainsi, le circuit DER selon le deuxième aspect ne comprend pas les interrupteurs IT25 et IT26, l'interrupteur IT13, et, dans des modes de réalisation où des éléments capacitifs C2' et C1' sont connectés en parallèle des éléments capacitifs C2 et C1 respectivement, l'élément capacitif C3' et l'entrée 228.

En outre, dans ce deuxième aspect, le circuit CTRL de commande des premiers interrupteurs (IT11 et IT12) et des deuxièmes interrupteurs (IT21 à IT24) est configuré pour mettre en œuvre des cycles successifs de fonctionnement, chaque cycle de fonctionnement correspondant à une succession de M=2 périodes du signal d'horloge interne du dispositif DER. Chaque cycle de fonctionnement comprend donc une première période du signal d'horloge interne, suivie d'une deuxième période du signal d'horloge interne, les cycles de fonctionnement successifs ne se chevauchant pas.

A chaque première période d'un cycle de fonctionnement, le circuit CTRL commande les premiers et deuxièmes interrupteurs pour que la tension V1 soit mémorisée sur l'élément capacitif C1, et, en outre, les entrées 208 et 210 du circuit DIFF reçoivent les tensions des éléments respectifs C1 et C2.

Plus particulièrement, à chaque première période, le circuit CTRL commande d'abord les premiers interrupteurs pour que la tension V1 soit mémorisée entre les bornes de l'élément capacitif C1, puis commande ensuite les deuxièmes interrupteurs pour que la deuxième borne de l'élément C1 soit couplée à l'entrée 208 du circuit DIFF et que la deuxième borne de l'élément C2 soit couplée à l'entrée 210.

Dit autrement, à chaque première période, le circuit CTRL maintien ouvert l'interrupteur IT12 et commute, pendant tout ou partie de cette première période, par exemple pendant la première moitié de cette première période, l'interrupteur IT11 à l'état passant. Pendant que l'interrupteur IT11 est passant, l'élément capacitif C1 se charge (ou se décharge) de sorte que la tension sur la deuxième borne de l'élément C1 devient égale à la tension V1. Lorsque l'interrupteur IT11 est de nouveau commuté à l'état bloqué, cela mémorise, sur l'élément capacitif C1, la tension présente entre ses bornes, cette tension étant égale à la tension V1 au moment de la commutation à l'état bloqué de l'interrupteur IT11. De préférence, pendant que l'interrupteur IT11 est à l'état passant, les interrupteurs IT22 à IT23 sont maintenus ouverts. Puis, le circuit CTRL commute, pendant tout ou partie de la première période, par exemple pendant la deuxième moitié de la première période, les interrupteurs IT21 et IT24 à l'état passant alors que les autres deuxièmes interrupteurs IT22 et IT23 sont maintenus ouverts. De cette manière, la deuxième borne de l'élément C1 est alors couplée à l'entrée 208 du circuit DIFF par l'interrupteur IT21 à l'état passant et la deuxième borne de l'élément C2 est couplée à l'entrée 210 du circuit DIFF par l'interrupteur IT24 à l'état passant.

La fenêtre temporelle pendant laquelle, pour chaque première période, le circuit CTRL couple avec les interrupteurs IT21 et IT24 les éléments C1 et C2 aux entrées respectives 208 et 210 pendant cette première période débute après que la tension V1 ait été mémorisée sur l'élément capacitif C1.

A chaque deuxième période d'un cycle de fonctionnement, le circuit CTRL commande les premiers et deuxièmes interrupteurs pour que la tension V1 soit mémorisée sur l'élément capacitif C2, et, en outre, les entrées 208 et 210 du circuit DIFF reçoivent les tensions des éléments respectifs C2 et C1.

Plus particulièrement, à chaque deuxième période, le circuit CTRL commande d'abord les premiers interrupteurs pour que la tension V1 soit mémorisée entre les bornes de l'élément capacitif C2, puis commande les deuxièmes interrupteurs pour que la deuxième borne de l'élément C2 soit couplée à l'entrée 208 du circuit DIFF et que la deuxième borne de l'élément C1 soit couplée à l'entrée 210.

Dit autrement, à chaque deuxième période, le circuit CTRL maintien ouvert l'interrupteur IT11 et commute, pendant tout ou partie de cette deuxième période, par exemple pendant la première moitié de cette deuxième période, l'interrupteur IT12 à l'état passant. Pendant que l'interrupteur IT12 est passant, l'élément capacitif C2 se charge (ou se décharge) à la tension V1. Lorsque l'interrupteur IT12 est de nouveau commuté à l'état bloqué, cela mémorise la tension V1 sur l'élément capacitif C2. De préférence, pendant que l'interrupteur IT12 est à l'état passant, les interrupteurs IT21 à IT24 sont maintenus ouverts. Puis le circuit CTRL commute, pendant tout ou partie de la deuxième période, par exemple pendant la deuxième moitié de la deuxième période, les interrupteurs IT23 et IT22 à l'état passant alors que les autres deuxièmes interrupteurs IT21 à IT24 sont maintenus ouverts. De cette manière, la deuxième borne de l'élément C2 est couplée à l'entrée 208 du circuit DIFF par l'interrupteur IT23 à l'état passant et la deuxième borne de l'élément C1 est couplée à l'entrée 210 du circuit DIFF par l'interrupteur IT24 à l'état passant.

La fenêtre temporelle pendant laquelle, pour chaque deuxième période, le circuit CTRL couple les éléments C2 et C1 aux entrées respectives 208 et 210 avec les interrupteurs IT22 et IT23 à l'état passant lors de cette première période débute après que la tension V1 ait été mémorisée sur l'élément capacitif C2.

Selon un mode de réalisation, chaque mémorisation de la tension V1 sur un élément capacitif C1, C2, a une même durée, c'est-à-dire que la fenêtre temporelle pendant laquelle le premier interrupteur IT11, IT12 correspondant est passant a la même durée pour chacune des premières et deuxièmes périodes du signal d'horloge interne. Cette durée est, par exemple, inférieure à la durée d'une période du signal d'horloge interne, par exemple égale à une demi-période du signal d'horloge interne.

En outre, la durée Ton séparant deux mémorisations successives, par exemple la durée Ton entre la mise à l'état bloqué de l'interrupteur IT11 et celle de l'interrupteur IT12, et entre la mise à l'état bloqué de l'interrupteur IT12 et celle de l'interrupteur IT11, est constante et est égale à une période du signal d'horloge d'interne.

Pour illustrer le fonctionnement du circuit DER décrit ci-dessus en relation avec le deuxième aspect, on considère un premier cycle et un deuxième cycle de fonctionnement successifs dans lesquels :
la tension V1 est mémorisée sur l'élément C1 à un instant t0 de la première période du premier cycle, d'où il résulte que, à la fin de la mémorisation, une tension Vc1 aux bornes de l'élément C1 est égale à V1(t0) ;
la tension V1 est mémorisée sur l'élément C2 à un instant t0 + Ton de la deuxième période du premier cycle, d'où il résulte que, à la fin de la mémorisation, une tension Vc2 aux bornes de l'élément C2 est égale à V1(t0+Ton) ;
la tension V1 est mémorisée sur l'élément C1 à un instant t0 + 2.Ton de la première période du deuxième cycle, d'où il résulte que, à la fin de la mémorisation, une tension Vc1 aux bornes de l'élément C1 est égale à V1(t0+2.Ton) ; et
la tension V1 est mémorisée sur l'élément C2 à un instant t0 + 3.Ton de la deuxième période du deuxième cycle, d'où il résulte que, à la fin de la mémorisation, la tension Vc2 aux bornes de l'élément C2 est égale à V1(t0+3.Ton).

Ainsi, dans cet exemple, lors de la deuxième période du premier cycle, lorsque les éléments C1 et C2 sont couplés aux entrées du circuit DIFF après la mémorisation de la tension V1 aux bornes de l'élément C2, la tension V3 est alors à une valeur déterminée par la différence entre la tension Vc2 aux bornes de l'élément C1 qui est égale à V1(t0+Ton) et la tension Vc1 aux bornes de l'élément C1 qui est égale à V1(t0), la tension V3 étant alors par exemple égale à A. (V1(t0+Ton)-V1(t0)). Comme la tension V1 est, dans cet exemple, égale à la tension V2, il en résulte que la tension V3 est égale à K. (V2(t0+Ton)-V2(t0))/Ton, donc à K fois la dérivée de la tension V2 à l'instant t0, avec K égal à A.Ton.

De manière similaire, lors de la première période du deuxième cycle, lorsque les éléments C1 et C2 sont couplés aux entrées du circuit DIFF après la mémorisation de la tension V1 aux bornes de l'élément C1, la tension V3 est alors à une valeur déterminée par la différence entre la tension Vc1 aux bornes de l'élément C1 qui est égale à V1(t0+2.Ton) et la tension Vc2 aux bornes de l'élément C2 qui est égale à V1(t0+Ton), la tension V3 étant alors par exemple égale à A. (V1(t0+2.Ton)-V1(t0+Ton)), donc à A. (V1(t1+Ton)-V1(t1)), avec t1 égal à t0+Ton. Comme précédemment, la tension V3 est égale à K. (V2(t2+Ton)-V2(t2))/Ton, donc à K fois la dérivée de la tension V2 à l'instant t1.

La personne du métier sera en mesure de déduire le fonctionnement du circuit DER lors des périodes d'horloges internes suivantes à partir du fonctionnement décrit ci-dessus à titre d'exemple.

Le circuit DER ci-dessus permet donc de fournir, à chaque période du signal d'horloge, une tension V3 indiquant la valeur de la dérivée de la tension V2, la valeur de cette tension V3 étant mise à jour à chaque période du signal d'horloge interne. Ainsi, il n'y a pas de cycle où aucune valeur de la tension V1 n'est échantillonnée, ni de cycle où aucune valeur de dérivée n'est fournie.

De manière avantageuse, le circuit DER ne comprend pas d'amplificateur opérationnel monté en dérivateur, ni de convertisseur analogique numérique et de microprocesseur.

Par rapport au circuit DER selon le premier aspect, le circuit DER selon le deuxième aspect est plus simple à mettre en œuvre. En revanche, alors que le circuit DER selon le premier aspect peut fournir une tension V3 qui, pour chaque valeur de dérivée calculée, peut rester stable pendant la durée Ton jusqu'à ce que la tension V3 soit mise à jour, dans le circuit DER selon le premier aspect, cette durée pendant laquelle chaque valeur de dérivée calculée peut rester stable est égale à la durée Ton moins la durée de la phase de mémorisation de la tension V1 sur l'un ou l'autre des éléments C1 et C2. La personne du métier sera en mesure de prévoir que les circuits utilisant la tension V3 viennent lire ou utiliser la valeur courante de la tension V3 à un instant où la tension V3 a une valeur stable.

### Troisième aspect

Dans ce troisième aspect, comme pour les premier et deuxième aspects décrits précédemment, le circuit DER comprend M éléments capacitifs, avec M entier positif et non nul. Le circuit DER met en œuvre des cycles de fonctionnement successifs comprenant chacun M périodes successives d'un signal d'horloge interne, et, à chaque période d'un cycle, le circuit DER commande une mémorisation d'une tension d'entrée sur un des M éléments capacitifs et, en outre, met en œuvre une différence entre une première tension mémorisée sur un des M éléments capacitifs à un premier instant et une deuxième tension représentative de la tension d'entrée à un deuxième instant postérieur au premier instant et séparé du premier instant par une durée constante, par exemple égal à une période de l'horloge interne.

Toutefois, par rapport au premier aspect où M est égal à 3 et au deuxième aspect où M est égal à 2, dans le troisième aspect, M est égal à 1.

Plus particulièrement, dans le troisième aspect, celui des M éléments capacitifs sur lequel s'effectue la mémorisation est donc le même à chaque période de chaque cycle. En outre, à chaque période de chaque cycle, la première tension est la tension aux bornes de l'élément capacitif sur lequel la tension d'entrée a été mémorisée à cette période, et la deuxième tension représentative de la tension d'entrée est directement la tension d'entrée.

Des modes de réalisation détaillés d'un circuit DER de calcul de dérivée selon le troisième aspect vont maintenant être décrits.

La figure 5 illustre un exemple de mode de réalisation du circuit DER de mesure d'une dérivée, par exemple d'une dérivée d'une tension représentative d'une grandeur physique, selon le troisième aspect.

Le circuit DER selon le troisième aspect comprend de nombreux éléments en commun avec le circuit DER selon le premier aspect, et seules les différences entre ces deux circuits sont ici mises en exergue. Ainsi, sauf indication contraire, tous ce qui a été décrit pour le circuit DER selon le premier aspect s'applique au circuit DER selon le troisième aspect.

En particulier, par rapport au circuit DER selon le premier aspect, le circuit DER selon le troisième aspect ne comprend que M=1 éléments capacitifs pour mémoriser la tension V1 représentative de (ou déterminée par) la tension V2 pour laquelle le circuit DER calcule la dérivée. Ainsi, par rapport au circuit DER selon le premier aspect, le circuit DER selon le troisième aspect ne comprend pas l'élément capacitif C3 et ne comprend pas non plus l'élément capacitif C2.

Le circuit DER selon le troisième aspect ne comprend donc pas non plus tous les autres éléments du circuit DER selon le premier aspect qui sont liés à l'élément capacitif C3 et à l'élément capacitif C2. Ainsi, le circuit DER selon le troisième aspect ne comprend pas les interrupteurs IT23 à IT26, les interrupteurs IT13 et IT12, et, dans des modes de réalisation où un élément capacitif C1' est connecté en parallèle de l'élément capacitif C1, les éléments capacitifs C3' et C2' et les entrées 228 et 226.

Dans ce troisième aspect, l'interrupteur IT21 couplant l'élément capacitif C1 à l'entrée 208 du circuit DIFF est omis. En outre, le noeud 202 sur lequel est disponible la tension V1 est couplé, par exemple par un circuit tampon analogique, ou connecté à l'entrée 208 du circuit DIFF.

En outre, dans ce troisième aspect, le circuit CTRL de commande des premier et deuxième interrupteurs (IT11, IT22) est configuré pour mettre en œuvre des cycles successifs de fonctionnement, chaque cycle de fonctionnement correspondant à une succession de M=1 période du signal d'horloge interne du dispositif DER. Dit autrement, chaque cycle de fonctionnement comprend uniquement une période du signal d'horloge interne, appelée première période dans la suite.

A chaque première période d'un cycle de fonctionnement, ou, dit autrement, à chaque période du signal d'horloge interne, le circuit CTRL commande les premier et deuxième interrupteurs pour que la tension V1 soit mémorisée sur l'élément capacitif C1, et, en outre, les entrées 208 et 210 du circuit DIFF reçoivent la tension V1 et la tension mémorisé aux bornes de l'élément capacitif C1.

Plus particulièrement, à chaque première période, le circuit CTRL commande d'abord le premier interrupteur IT11 pour que la tension V1 soit mémorisée entre les bornes de l'élément capacitif C1, puis commande ensuite le deuxième interrupteur IT22 pour que la deuxième borne de l'élément C1 soit couplée à l'entrée 210 du circuit DIFF et que le noeud 202 soit couplé à l'entrée 208 du circuit DIFF.

Dit autrement, à chaque première période, le circuit CTRL commute, pendant tout ou partie de cette première période, par exemple pendant la première moitié de cette première période, l'interrupteur IT11 à l'état passant. Pendant que l'interrupteur IT11 est passant, l'élément capacitif C1 se charge (ou se décharge) à la tension V1. Lorsque l'interrupteur IT11 est de nouveau commuté à l'état bloqué, cela mémorise, sur l'élément capacitif C1, la tension V1 au moment de la commutation à l'état bloqué de l'interrupteur IT11. Puis, le circuit CTRL commute, pendant tout ou partie de la première période, par exemple pendant la deuxième moitié de la première période, l'interrupteur IT22 à l'état passant. De cette manière, la deuxième borne de l'élément C1 est alors couplée à l'entrée 210 du circuit DIFF par l'interrupteur IT21 à l'état passant et la tension V1 est fournie à l'entrée 208 du circuit DIFF.

La fenêtre temporelle pendant laquelle, pour chaque première période, le circuit CTRL couple, avec l'interrupteur IT22, l'élément C1 à l'entrée 210 débute après que la tension V1 ait été mémorisée sur ce même élément capacitif C1.

Selon un mode de réalisation, chaque mémorisation de la tension V1 sur l'élément capacitif C1, a une même durée, c'est-à-dire que la fenêtre temporelle pendant laquelle le premier interrupteur IT11 est passant a la même durée pour chaque première période du signal d'horloge interne. Cette durée est, par exemple, inférieure à la durée d'une période du signal d'horloge interne, par exemple égale à une demi-période du signal d'horloge interne.

En outre, la durée Ton séparant deux mémorisations successives, par exemple la durée Ton entre la mise à l'état bloqué de l'interrupteur IT11 lors de la première période d'un cycle de fonctionnement donné et celle de l'interrupteur IT11 lors de la première période du cycle de fonctionnement suivant, est constante et égale à une période du signal d'horloge d'interne.

Pour illustrer le fonctionnement du circuit DER décrit ci-dessus en relation avec le troisième aspect, on considère un premier cycle et un deuxième cycle de fonctionnement successifs dans lesquels :
la tension V1 est mémorisée sur l'élément C1 à un instant t0 de la première période du premier cycle, d'où il résulte que, à la fin de la mémorisation, une tension Vc1 aux bornes de l'élément C1 est égale à V1(t0) ; et
la tension V1 est mémorisée sur l'élément C1 à un instant t0 + Ton de la première période du deuxième cycle, d'où il résulte que, à la fin de la mémorisation, la tension Vc1 aux bornes de l'élément C1 est égale à Vl(t0+Ton).

Ainsi, dans cet exemple, lors de la première période de chaque cycle, lorsque l'élément C1 est couplé à l'entrée 210 du circuit DIFF après la mémorisation de la tension V1 aux bornes de l'élément C1, la tension V3 est alors à une valeur déterminée par la différence entre la tension Vc1 aux bornes de l'élément C1 qui est égale à V1(t0) et la tension V1 qui est égale à V1(t), avec t un instant de cette première période postérieur à l'instant t0. Par exemple, lorsque l'instant t0 correspond à la fin de la première moitié de la première période, que la tension V3 est lue à un instant t1 correspondant à la fin de la deuxième moitié de la première période, et que Ton correspond à la durée d'une période du signal d'horloge interne, la tension V3 à la fin de la première période (instant t1) est alors par exemple égale à A. (V1(t0+(Ton/2))-V1(t0)). Comme la tension V1 est, dans cet exemple, égale à la tension V2, il en résulte que la tension V3, à l'instant t1, est égale à K.(V2(t0+(Ton/2))-V2(t0))/(Ton/2), donc à K fois la dérivée de la tension V2 à l'instant t0, avec K égal à A.Ton/2.

Le circuit DER ci-dessus permet donc de fournir, à chaque période du signal d'horloge, une tension V3 indiquant la valeur de la dérivée de la tension V2, la valeur de cette tension V3 étant mise à jour à chaque période du signal d'horloge interne. Ainsi, il n'y a pas de cycle où aucune valeur de la tension V1 n'est échantillonnée, ni de cycle où aucune valeur de dérivée n'est fournie.

On a décrit ci-dessus un exemple où une demi période du signal d'horloge interne sépare, à chaque cycle, l'instant t0 de fin de mémorisation de la tension V1 sur C1, de l'instant t1 où la tension V3 est lue, d'où il résulte que la tension V3(t1) à l'instant t1 est égale à K fois la dérivée de la tension V2 avec K égal à A.Ton/2. La personne du métier pourra choisir une autre valeur de durée, par exemple Ton/4, séparant l'instant t0 de l'instant t1, d'où il résulte que la tension V3(t1) sera égale à K fois la dérivée de la tension V2 avec K différent de A.Ton/2, par exemple égal à A.Ton/4.

De manière avantageuse, le circuit DER ne comprend pas d'amplificateur opérationnel monté en dérivateur, ni de convertisseur analogique numérique et de microprocesseur.

Par rapport au circuit DER selon les premier et deuxième aspects, le circuit DER selon le troisième aspect est plus simple à mettre en œuvre. En revanche, alors que le circuit DER selon le premier aspect peut fournir une tension V3 qui, pour chaque valeur de dérivée calculée, peut rester stable pendant la durée Ton jusqu'à ce que la tension soit mise à jour, et que le circuit DER selon le deuxième aspect peut fournir une tension V3 qui, pour chaque valeur de dérivée calculée, peut rester stable pendant la durée Ton moins la durée de la phase de mémorisation de la tension V1 sur l'un ou l'autre des éléments C1 et C2, dans le circuit DER selon le troisième aspect, la valeur de la tension V3 devra être lue à un instant t1 prédéfini, par exemple à la fin de chaque période du signal interne, pour connaître le facteur K entre la tension V3 et la valeur de la dérivée de la tension V1 à cet instant t1. La personne du métier sera en mesure de prévoir que les circuits utilisant la tension V3 viennent lire ou utiliser la valeur courante de la tension V3 à l'instant t1 où la tension V3 est bien égale à K fois la dérivée de la tension V1, par exemple en prévoyant de mémoriser la valeur de la tension V3 à cet instant t1.

### Quatrième aspect

Dans les modes de réalisation décrits précédemment en relation avec l'un quelconque des premier, deuxième et troisième aspect, la valeur ou tension V3 représentative de la valeur calculée de la dérivée de la tension d'entrée V2 est comparée à un seuil TH déterminé par la tension Vref. Une alarme ODP est déclenchée dés que la valeur de la dérivée calculée dépasse ce seuil, c'est-à-dire dès que la tension V3 dépasse le seuil Vref.

Dans ces modes de réalisation, le seuil TH et la tension Vref correspondante sont constants. Ainsi, lorsque la tension V1 a une valeur faible représentant une valeur faible de la grandeur physique correspondante (par exemple un courant dans une résistance), et que cette tension V1 augmente brusquement, la tension V3 peut passer au-dessus du seuil Vref et déclencher une alarme ODP alors que, en pratique, la tension V1 peut, après son augmentation brusque, atteindre une valeur stable en dessous d'un seuil de valeur de la tension V1 pour laquelle il n'est pas nécessaire de prévoir d'action (par exemple une diminution d'une valeur de la résistance). Dans ce cas, une alarme ODP est déclenchée alors que cela n'est pas nécessaire. A l'inverse, lorsque la tension V1 a une valeur élevée représentant une valeur élevée de la grandeur physique correspondante (par exemple un courant dans une résistance), et que cette valeur est très proche du seuil de valeur de la tension V1 pour laquelle il est nécessaire de prévoir une action (par exemple une diminution d'une valeur de la résistance), si la tension V1 augmente lentement jusqu'à atteindre ce seuil de valeur, la tension V3 reste en dessous du Vref, et ne déclenche pas d'alarme ODP en avance par rapport au moment où la tension V1 dépasse son seuil de valeur. Dans ce cas, aucune alarme ODP n'est déclenché alors que cela aurait été souhaitable.

Ainsi, dans le quatrième aspect, une valeur de dérivée calculée, ou une grandeur représentative de cette valeur calculée, par exemple la tension V3, est toujours comparée à un seuil, par exemple Vref, et une alarme est déclenchée au moins en partie sur la base du résultat de cette comparaison. Toutefois, dans le quatrième aspect, le seuil est dépendant de la valeur courante de la grandeur sur laquelle est calculée la dérivée. Dit autrement, la valeur du seuil est adaptée au moins à partir de la valeur courante de la tension, par exemple V1, sur laquelle est calculée la dérivée.

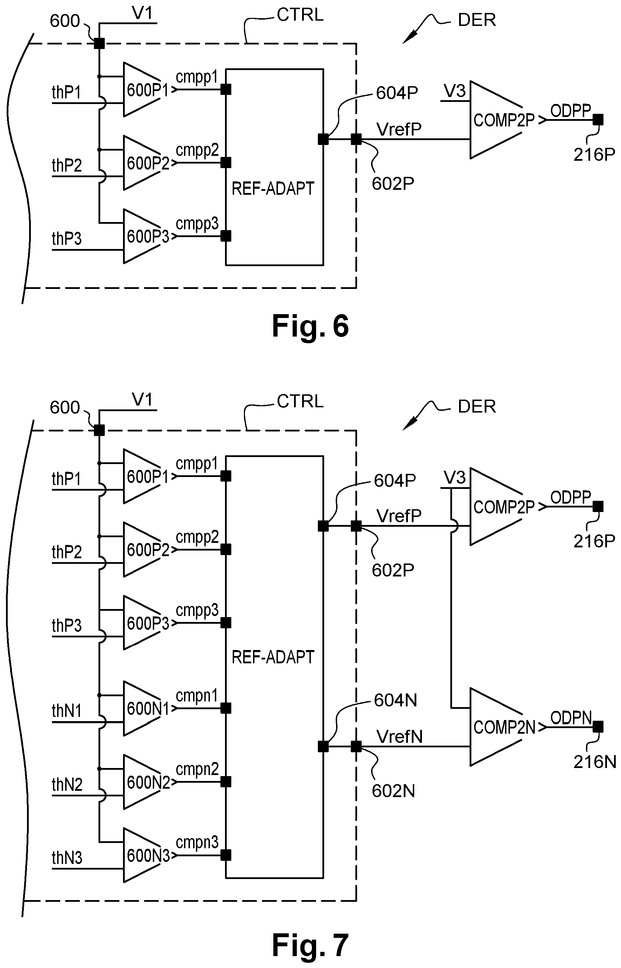

La figure 6 illustre un exemple de mode de réalisation du circuit DER de mesure d'une dérivée, par exemple d'une dérivée d'une tension V1 représentative d'une grandeur physique, selon le quatrième aspect.

En figure 6, le circuit DER et le circuit CTRL sont partiellement représentés.

Dans cet exemple, la tension V1 est positive et croissante avec la grandeur physique, par exemple un courant dans une résistance, qu'elle représente.

Dans cet exemple, la dérivée de la tension V3 est comparée à un seuil positif désigné dans la suite par la référence THP.

Dans cet exemple, la tension représentative du seuil THP à laquelle est comparée la tension V3 pour fournir un signal d'alarme est référencée VrefP et est positive, le signal binaire d'alarme est référencé ODPP, le comparateur comparant la tension V3 à la tension Vref pour fournir le signal d'alarme est référencé COMP2P et la sortie 216 fournissant le signal d'alarme ODPP est référencée 216P en lieu et place des références respectives Vref, ODP, COMP2 et 216 utilisées dans les figures 2 à 5 décrites précédemment.

Dans ce mode de réalisation, le circuit CTRL comprend une entrée 600 configurée pour recevoir la tension V1. En outre, le circuit CTRL est configuré pour diminuer, de préférence de manière discrète, la valeur du seuil THP, donc celle de la tension VrefP, lorsque la tension V1 augmente, et pour augmenter la valeur de seuil THP, donc celle de la tension VrefP, lorsque la tension V1 diminue.

Dans ce mode de réalisation, le circuit CTRL comprend en outre une sortie 602P configurée pour fournir la tension de seuil VrefP au comparateur COMP2P du circuit DER, ce dernier recevant également la tension V3 représentative de la dérivée de la tension V1. Comme précédemment décrit, le comparateur COMP2P est configuré pour comparer la tension V3 à la tension VrefP, et pour fournir un signal ODPP binaire représentatif du résultat de cette comparaison.

Dans ce mode de réalisation, le signal ODPP est fourni à la sortie 216P du circuit DER.

Selon un mode de réalisation, le circuit CTRL comprend Q comparateurs 600Pi (600P1, 600P2, 600P3 en figure 6), avec Q entier positif supérieur ou égal à 1, de préférence supérieur ou égal à 2, par exemple égal à 3 en figure 6, et i un indice entier allant de 1 à Q.

Chaque comparateur 600Pi est configuré pour comparer la tension V1 à un seuil positif thPi correspondant (thP1, thP2, thP3 en figure 6), les seuils thPi étant différents les uns des autres. Chaque comparateur 600Pi fournit un signal binaire cmppi (cmpp1, cmpp2, cmpp3 en figure 6) représentatif du résultat de cette comparaison.

Le circuit CTRL comprend en outre un circuit REF-ADAPT configuré pour fournir la tension VrefP, par exemple sur une sortie 604P du circuit CTRL, et pour adapter la valeur de cette tension VrefP en fonction des signaux cmppi, c'est à dire en fonction de la valeur courante de la tension V1. A titre d'exemple le circuit REF-ADAPT reçoit les signaux cmppi sur des entrées correspondantes du circuit REF-ADAPT.

Par exemple, dans le cas où la valeur des seuils thPi augmente avec l'indice i et où la tension V1 est croissante avec la grandeur physique qu'elle représente, le circuit REF-ADAPT est configuré pour fournir la tension VrefP a une valeur maximale lorsque la tension V1 est inférieure au seuil thP1, à une première valeur plus faible que la valeur maximale lorsque la tension V1 est comprise entre les seuils thP1 et thP2, à une deuxième valeur plus faible que la première valeur lorsque la tension V1 est comprise entre les seuils thP2 et thP3, et à une valeur minimale plus faible que la deuxième valeur lorsque la tension V1 est supérieure au seuil thP3.

A titre d'exemple, bien que cela ne soit pas illustré en figure 6, le circuit REF-ADAPT comprend un pont diviseur résistif ayant un noeud intermédiaire configuré pour fournir la tension VrefP, et une valeur d'un élément résistif de ce pont diviseur est commandée par les signaux cmppi de sorte à obtenir le fonctionnement décrit ci-dessus. La mise en œuvre d'un tel circuit est à la portée de la personne du métier à partir des indications fonctionnelles données ci-dessus. En outre, la personne du métier sera en mesure de prévoir d'autres mises en œuvre du circuit REF-ADAPT ayant le fonctionnement décrit ci-dessus.

La figure 7 illustre un autre exemple de mode de réalisation du circuit DER de mesure d'une dérivée, par exemple d'une dérivée d'une tension V1 représentative d'une grandeur physique, selon le quatrième aspect.

En figure 7, comme en figure 6, le circuit DER et le circuit CTRL sont partiellement représentés. Le circuit DER décrit en relation avec la figure 7 comprend de nombreux éléments en commun avec le circuit DER décrit en relation avec la figure 6, et seules les différences entre ces deux circuits DER sont ici mises en exergue.

Dans cet exemple, la tension V1 est croissante avec la grandeur physique, par exemple un courant dans une résistance, qu'elle représente. En outre, dans cet exemple, la tension V1 prend des valeurs positives et des valeurs négatives. Par exemple, cela peut être le cas lorsque la tension V1 représente la valeur d'un courant dans une résistance et que ce courant peut circuler dans un sens et dans un autre dans la résistance.

De la même façon qu'une alarme ODPP indique lorsque la dérivée de la tension V1 dépasse un seuil positif THP, il est alors souhaitable qu'une alarme ODPN indique lorsque la dérivée de la tension V1 dépasse un seuil négatif THN, c'est à dire passe en dessous de ce seuil négatif THN. De cette façon, lorsque la tension V1 est négative et décroît, si la valeur de la dérivée de la tension V1 passe en dessous du seuil THN, une alarme ODPN est déclenchée, et une action correspondante peut être mise en œuvre de manière anticipée, sans attendre que la tension V1 passe en dessous d'un seuil de valeur négatif.

Ainsi, dans cet exemple, de manière symétrique à ce qui a été décrit précédemment en relation avec la figure 6, il est prévu que la dérivée de la tension V1 soit comparée à un seuil négatif THN, en plus d'être comparée au seuil positif THP. Le circuit DER est alors configuré pour fournir un signal binaire d'alarme ODPN supplémentaire indiquant lorsque la valeur de la dérivée de la tension V1 est inférieure au seuil THN.

Dans cet exemple, la tension représentative du seuil THN à laquelle est comparée la tension V3 pour fournir le signal d'alarme ODPN est référencée VrefN et est négative, le circuit DER comprenant alors un comparateur COMP2N supplémentaire comparant la tension V3 à la tension VrefN et fournissant le signal binaire d'alarme ODPN. En outre, le circuit DER comprend une sortie supplémentaire 216N configurée pour fournir le signal ODPN.

Dans ce mode de réalisation, le circuit CTRL est en outre configuré pour diminuer, de préférence de manière discrète, la valeur absolue du seuil THN, donc celle de la tension VrefP, lorsque la tension V1 est négative et diminue, ou, dit autrement, lorsque la tension V1 est négative et augmente en valeur absolue. En outre, le circuit CTRL est configuré pour augmenter la valeur absolue du seuil THN, donc celle de la tension VrefN lorsque la tension V1 est négative et augmente, ou, dit autrement, lorsque la tension V1 est négative et diminue en valeur absolue.

Dans ce mode de réalisation, le circuit CTRL comprend en outre une sortie 602N configurée pour fournir la tension de seuil VrefN au comparateur COMP2N du circuit DER, ce dernier recevant également la tension V3 représentative de la dérivée de la tension V1. Le comparateur COMP2N est configuré pour comparer la tension V3 à la tension VrefN, et pour fournir le signal binaire ODPN représentatif du résultat de cette comparaison.

Dans ce mode de réalisation, le signal ODPN est fourni à la sortie 216N du circuit DER.

Selon un mode de réalisation, le circuit CTRL comprend, en plus des Q comparateurs 600Pi fournissant les signaux cmppi, K comparateurs 600Nj (600N1, 600N2, 600N3 en figure 7), avec K entier positif supérieur ou égal à 1, de préférence supérieur ou égal à 2, par exemple égal à 3 en figure 7, et j un indice entier allant de 1 à K. De préférence, les nombres K et Q sont égaux bien que, dans d'autres exemples, les nombres K et Q puissent être différents.

Chaque comparateur 600Nj est configuré pour comparer la tension V1 à un seuil négatif thNj correspondant (thN1, thN2, thN3 en figure 7), les seuils thNj étant différents les uns des autres. Chaque comparateur 600Nj fournit un signal binaire cmpnj (cmpn1, cmpn2, cmpn3 en figure 7) représentatif du résultat de cette comparaison.

Le circuit REF-ADAPT est configuré pour fournir la tension VrefN, par exemple sur une sortie 604N du circuit CTRL, en plus de la tension VrefP qu'il fournit, par exemple, à sa sortie 604P. Le circuit REF-ADAPT est en outre configuré pour adapter la valeur de cette tension VrefN en fonction des signaux cmpnj, c'est à dire en fonction de la valeur courante de la tension V1. A titre d'exemple le circuit REF-ADAPT reçoit les signaux cmpni sur des entrées correspondantes du circuit REF-ADAPT.

Par exemple, dans le cas où la valeur absolue des seuils thNj augmente avec l'indice j et où la tension V1 est croissante avec la grandeur physique qu'elle représente, le circuit REF-ADAPT est configuré pour fournir la tension négative VrefN à une valeur absolue maximale lorsque la tension négative V1 est, en valeur absolue, inférieure à la valeur absolue du seuil négatif thP1, à une première valeur plus faible, en valeur absolue, que la valeur absolue de la valeur maximale lorsque la tension V1 est comprise entre les seuils thP1 et thP2, à une deuxième valeur plus faible, en valeur absolue, que la valeur absolue de la première valeur lorsque la tension V1 est comprise entre les seuils thP2 et thP3, et à une valeur absolue minimale plus faible, en valeur absolue, que la valeur absolue de la deuxième valeur lorsque la tension V1 est, en valeur absolue, supérieure à la valeur absolue du seuil thP3. Dit autrement, le circuit REF-ADAPT est configuré pour fournir la tension négative VrefN à une valeur négative maximale lorsque la tension négative V1 est comprise entre une valeur nulle et le seuil négatif thP1, à une première valeur négative plus proche d'une valeur nulle que la valeur négative maximale lorsque la tension V1 est comprise entre les seuils thP1 et thP2, à une deuxième valeur négative plus proche d'une valeur nulle que la première valeur négative lorsque la tension V1 est comprise entre les seuils thP2 et thP3, et à une valeur négative minimale plus proche d'une valeur nulle que la deuxième valeur négative lorsque la tension V1 est plus négative que le seuil thP3.

A titre d'exemple, bien que cela ne soit pas illustré en figure 7, le circuit REF-ADAPT comprend, par exemple en plus du pont résistif fournissant la tension VrefP, un pont diviseur résistif ayant un noeud intermédiaire configuré pour fournir la tension VrefN, une valeur d'un élément résistif de ce pont diviseur étant commandée par les signaux cmpnj de sorte à obtenir le fonctionnement décrit ci-dessus. La mise en œuvre d'un tel circuit est à la portée de la personne du métier à partir des indications fonctionnelles données ci-dessus. En outre, la personne du métier sera en mesure de prévoir d'autres mises en œuvre du circuit REF-ADAPT ayant le fonctionnement décrit ci-dessus.

Bien que l'on ait décrit, en relation avec la figure 6, un exemple de mode de réalisation dans lequel la tension V1 est positive et la dérivée de la tension V1 est comparée à un seuil variable THP positif, et, en relation avec la figure 7, un exemple de mode de réalisation dans lequel la tension V1 prend des valeurs positives et négatives et sa dérivée est comparée au seuil variable THP positif et à un seuil variable THN négatif, dans une variante de réalisation, la tension V1 est négative et sa dérivée est comparée au seul seuil variable THN négatif. La mise en œuvre d'une telle variante est à la portée de la personne du métier à partir de la description du circuit DER faite ci-dessus en relation avec les figures 6 et 7.

Par exemple, dans une telle variante, par rapport au circuit DER décrit en relation avec la figure 7, le comparateur COMP2P et la sortie 216P sont omis, et en outre, le circuit CTRL ne fournit pas la tension VrefP et ne comprend pas la sortie 602P. Le circuit CTRL n'est donc pas configuré pour adapter la valeur de la tension VrefP en fonction de la valeur courante de la tension V1, ou, dit autrement, le circuit REF-ADAPT ne fournit pas la tension VrefP, ne comprend pas la sortie 604P, et n'est pas configuré pour adapter la valeur de la tension VrefP en fonction de la valeur courante de la tension V1. Par exemple, le circuit CTRL ne comprend pas les comparateurs 600Pi.

Dans les exemples de modes de réalisation et variantes décris ci-dessus en relation avec les figures 6 et 7 :
- lorsque la tension V1 est positive et augmente, la valeur du seuil positif THP, donc celle de la tension positive VrefP, diminue à chaque fois que la tension V1 devient supérieure à l'un des seuils thPi, et, à l'inverse, lorsque la tension V1 est positive et diminue, la valeur du seuil THP, donc celle de la tension VrefP, augmente à chaque fois que la tension V1 devient inférieure à l'un des seuils thPi ; et/ou
- lorsque la tension V1 est négative et augmente en valeur absolue, la valeur du seuil négatif THN, donc celle de la tension négative VrefN, diminue en valeur absolue à chaque fois que la valeur absolue de tension V1 devient supérieure à la valeur absolue à l'un des seuils thNj, et, à l'inverse, lorsque la tension V1 est négative et diminue en valeur absolue, la valeur du seuil négatif THN, donc celle de la tension négative VrefN, augmente en valeur absolue à chaque fois que la valeur absolue de tension V1 devient inférieure à la valeur absolue à l'un des seuils thNj.

Dit autrement, dans ces modes de réalisation et variantes, la valeur absolue du seuil THP (tension VrefP) et/ou la valeur absolue du seuil THN (tension VrefN) sont adaptées chacune, de préférence de manière discrète, à la hausse et à la baisse uniquement sur la base de la valeur de la tension V1.

Dans d'autres modes de réalisation et variantes, il est souhaitable que :
- lorsque la tension V1 est positive :
   si la tension V1 augmente, la valeur du seuil positif THP, donc celle de la tension positive VrefP, diminue à chaque fois que la tension V1 devient supérieure à l'un des seuils thPi, et
   si la tension V1 diminue, la valeur du seuil THP, donc celle de la tension VrefP, augmente à chaque fois que la tension V1 devient inférieure à l'un des seuils thPi si la dérivée de la tension V1, c'est à dire la tension V3, est négative, et n'est pas modifiée si la dérivée de la tension V1 est positive ; et/ou
- lorsque la tension V1 est négative :
   si la tension V1 augmente en valeur absolue, la valeur du seuil négatif THN, donc celle de la tension négative VrefN, diminue en valeur absolue à chaque fois que la valeur absolue de tension V1 devient supérieure à la valeur absolue de l'un des seuils thNj, et
   si la tension V1 diminue en valeur absolue, la valeur du seuil THN, donc celle de la tension VrefN, augmente en valeur absolue à chaque fois que la valeur absolue de la tension V1 devient inférieure à l'un des seuils thNi si la dérivée de la tension V1, c'est à dire la tension V3, est positive, et n'est pas modifiée si la dérivée de la tension V1 est négative.

Dans ces modes de réalisation et variantes, la valeur courante du seuil THP et/ou la valeur courante du seuil THN sont modifiées chacune, en valeur absolue :
- à la baisse uniquement sur la base de la valeur courante de la tension V1, et
- à la hausse sur la base non seulement de la valeur courante de la tension V1 mais également en tenant compte de la polarité de la dérivée de la tension V1, c'est à dire de la polarité de la tension V3.

Cela permet de tenir compte du délai entre une augmentation de la valeur absolue de la tension V1, et la variation correspondante de la valeur de la dérivée, c'est-à-dire de la valeur de la tension V3, lors de la comparaison de la tension V3 à l'une et/ou l'autre des tensions VrefP et VrefN, et, en particulier, du fait que la tension V1 peut, en valeur absolue, diminuer pendant ce délai.

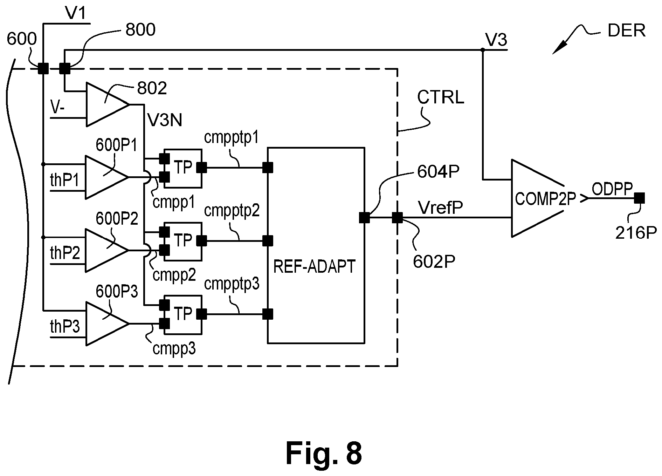

La figure 8 illustre un exemple d'un tel mode de réalisation du circuit DER. Plus particulièrement, la figure 8 représente une adaptation du mode de réalisation du circuit DER décrit en relation avec la figure 6, dans le cas où la modification à la hausse du seuil THP, donc de la tension VrefP, en fonction de la valeur de la tension V1 est conditionnée par la polarité de la dérivée, c'est à dire par la polarité de la tension V3. Par exemple, en figure 8, la modification à la hausse du seuil THP, donc de la tension VrefP, n'est effective que si la dérivée de la tension V1, c'est à dire la tension V3, est négative.

Ainsi, le circuit DER de la figure 8 comprend de nombreux éléments en commun avec celui de la figure 6, et seules les différences entre ces deux circuits sont ici mises en exergue. En outre, comme en figure 6, en figure 8 le circuit DER et son circuit CTRL sont partiellement représentés.

En figure 8, le circuit CTRL est configuré pour mettre en œuvre le fonctionnement décrit ci-dessus où la tension VrefP est adaptée à la baisse quand la tension V1 augmente, et est adaptée à hausse, par exemple lorsque la tension V1 diminue, en fonction de la valeur de la tension V1 et de la polarité de la tension V3.

A titre d'exemple, le circuit CTRL comprend une entrée 800 supplémentaire configurée pour recevoir la tension V3. Le circuit DER comprend également un comparateur 802 supplémentaire configuré pour comparer la tension V3 à une tension V- nulle ou légèrement négative, et fournir un signal binaire V3N indiquant le résultat de cette comparaison, c'est à dire la polarité (positive ou négative) de la tension V3.

Par exemple, la tension V- est comprise dans une plage de valeurs allant de 0 V à -100 mV. La tension V- est par exemple égale à -50 mV.

En outre, dans l'exemple de circuit DER de la figure 8, les signaux cmppi ne sont pas directement fournis au circuit REF-ADAPT, mais sont fournis chacun à un circuit TP correspondant. Chaque circuit TP reçoit en outre le signal V3N et est configuré pour fournir un signal binaire cmpptpi (cmpptp1, cmpptp2, cmpptp3 en figure 8) déterminé par les signaux cmppi et V3N reçus par ce circuit TP.

Plus particulièrement, chaque circuit TP est, par exemple, configuré pour :
- commuter son signal cmpptpi d'un premier état binaire de ce signal à un deuxième état binaire de ce signal lorsque son signal cmppi commute d'un premier état binaire de ce signal indiquant que la tension V1 est inférieure au seuil thPi à un deuxième état binaire de ce signal indiquant que la tension V1 est supérieure au seuil thPi ;
- commuter son signal cmpptpi de son deuxième état binaire à son premier état binaire lorsque son signal cmppi est à son premier état binaire et que, simultanément, le signal V3N indique que la tension V3 est négative ; et
- maintenir le signal cmpptpi à son état courant sinon.

Dans cet exemple de circuit CTRL, le circuit REF-ADAPT modifie la valeur de la tension VrefP à chaque modification de l'état binaire d'un des signaux cmpptpi. Par exemple, le circuit REF-ADAPT reçoit les signaux cmpptpi à la place des signaux cmppi. Par exemple, le circuit REF-ADAPT diminue la valeur de la tension VrefP à chaque fois qu'un signal cmpptpi commute de son premier état binaire à son deuxième état binaire, et augmente la valeur de la tension VrefP à chaque fois qu'un signal cmpptpi commute de son deuxième état binaire à son premier état binaire.

A titre d'exemple, la personne du métier pourra mettre en œuvre chaque circuit TP à partir d'une bascule de type RS ("RS flip-flop" en anglais) ayant une entrée d'initialisation S commandée uniquement sur la base du signal cmppi reçu par ce circuit TP, une entrée de réinitialisation R commandée sur la base d'une combinaison combinatoire des signaux cmppi et V3N reçus par ce circuit TP, et une sortie Q fournissant ou déterminant le signal cmpptpi fourni par ce circuit TP.

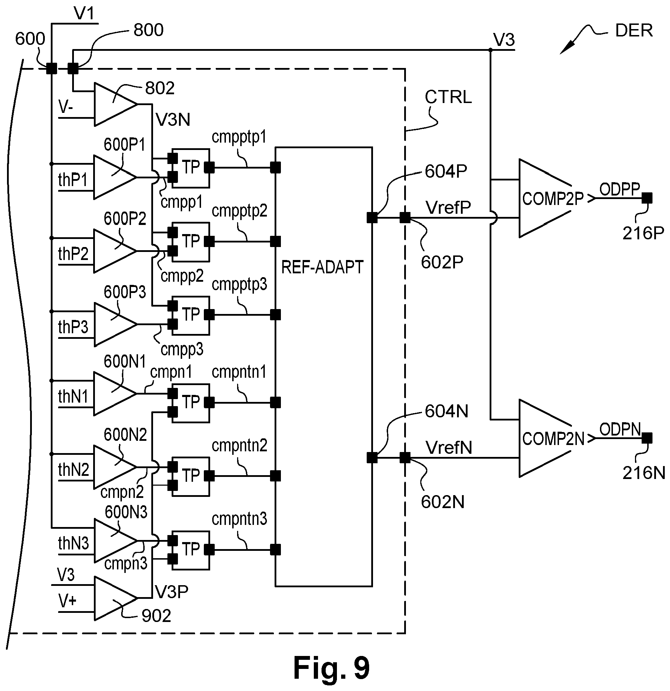

La figure 9 illustre un autre exemple d'un tel mode de réalisation du circuit DER. Plus particulièrement, la figure 9 représente une adaptation du mode de réalisation du circuit DER décrit en relation avec la figure 7, dans le cas où :
- la modification à la hausse du seuil THP, donc de la tension VrefP, en fonction de la valeur de la tension V1 est conditionnée par la polarité de la dérivée, c'est à dire par la polarité de la tension V3, par exemple en conditionnant chaque modification à la hausse de la tension VrefP au fait que la dérivée de la tension V1, c'est à dire la tension V3, soit négative ; et
- la modification à la hausse de la valeur absolue du seuil THN, donc de la valeur absolue de la tension VrefN, en fonction de la valeur de la tension V1 est conditionnée par la polarité de la dérivée, c'est à dire par la polarité de la tension V3, par exemple en conditionnant chaque modification à la hausse de la valeur absolue de la tension VrefN au fait que la dérivée de la tension V1, c'est à dire la tension V3, soit positive.

Ainsi, le circuit DER de la figure 9 comprend de nombreux éléments en commun avec celui de la figure 7, et seules les différences entre ces deux circuits sont ici mises en exergue. En outre, comme en figure 7, en figure 9 le circuit DER et son circuit CTRL sont partiellement représenté.

En figure 9, le circuit CTRL est configuré pour mettre en œuvre le fonctionnement décrit ci-dessus où les modifications à la baisse de la valeur absolue de chacune des tensions VrefP et VrefN ne dépendent que de la valeur courante de la tension V1, et les modifications à la hausse de la valeur absolue de chacune des tensions VrefP et VrefN dépendent non seulement de la valeur courante de la tension V1, mais sont en outre conditionnées par la polarité de la tension V3, ou, dit autrement, ces modifications à la hausse dépendent de la valeur courante de la tension V1 et de la polarité de la tension V3.

A titre d'exemple, pour cela, le circuit CTRL comprend un comparateur 902 supplémentaire configuré pour comparer la tension V3 à une tension V+ nulle ou légèrement positive, et fournir un signal binaire V3P indiquant le résultat de cette comparaison, c'est à dire la polarité (positive ou négative) de la tension V3.

Par exemple, la tension V+ est comprise dans une plage de valeurs allant de 0 V à 100 mV. La tension V+ est par exemple égale à +50 mV.

En outre, dans l'exemple de circuit DER de la figure 8, les signaux cmpnj ne sont pas directement fournis au circuit REF-ADAPT, mais sont fournis chacun à un circuit TN correspondant. Chaque circuit TN reçoit en outre le signal V3P et est configuré pour fournir un signal binaire cmpntnj (cmpntn1, cmpntn2, cmpntn3 en figure 9) déterminé par les signaux cmpnj et V2N reçus par ce circuit TN.

Plus particulièrement, chaque circuit TN est, par exemple, configuré pour :
- commuter son signal cmpntnj d'un premier état binaire de ce signal à un deuxième état binaire de ce signal lorsque son signal cmpnj commute d'un premier état binaire de ce signal indiquant que la tension V1 est négative et inférieure en valeur absolue à la valeur absolue du seuil thNj, à un deuxième état binaire de ce signal indiquant que la tension V1 est négative et supérieure en valeur absolue à la valeur absolue du seuil thNi ;
- commuter son signal cmpntnj de son deuxième état binaire à son premier état binaire lorsque son signal cmpnj est à son premier état binaire et que, simultanément, le signal V3P indique que la tension V3 est positive ; et
- maintenir le signal cmpntnj à son état courant sinon.

Dans cet exemple de circuit CTRL, le circuit REF-ADAPT modifie la valeur de la tension VrefN à chaque modification de l'état binaire d'un des signaux cmpntnij. Par exemple, le circuit REF-ADAPT reçoit les signaux cmpntnj à la place des signaux cmpnj. Par exemple, le circuit REF-ADAPT diminue, en valeur absolue, la valeur de la tension VrefN à chaque fois qu'un signal cmpntnj commute de son premier état binaire à son deuxième état binaire, et augmente, en valeur absolue, la valeur de la tension VrefN à chaque fois qu'un signal cmpntnj commute de son deuxième état binaire à son premier état binaire.

A titre d'exemple, la personne du métier pourra mettre en œuvre chaque circuit TN à partir d'une bascule de type RS ("RS flip-flop" en anglais) ayant une entrée d'initialisation S commandée uniquement sur la base du signal cmpnj reçu par ce circuit TN, une entrée de réinitialisation R commandée sur la base d'une combinaison combinatoire des signaux cmpnj et V3P reçus par ce circuit TN, et une sortie Q fournissant ou déterminant le signal cmpntnj fourni par ce circuit TP.

Dans encore d'autres modes de réalisation, plutôt que de fournir les signaux binaire d'alarme ODPP et ODPN, il est souhaitable que le circuit DER soit configuré pour :
- fournir un signal binaire d'alarme ODPPP à un premier état binaire indiquant que la dérivée de la tension V1 est supérieure au seuil VrefP, c'est à dire indiquant que la valeur courante de la tension V3 est supérieure à la tension VrefP, uniquement si la tension V1 est positive, et, plus particulièrement, uniquement si la dernière valeur de la tension V1 utilisée pour calculer cette valeur courante de la tension V3 est positive, et
- fournir un signal binaire d'alarme ODPNN à un premier état binaire indiquant que la dérivée de la tension V1 est inférieure au seuil VrefN, c'est à dire indiquant que la valeur courante de la tension V3 est inférieure à la tension VrefN, uniquement si la tension V1 est négative, et, plus particulièrement, uniquement si la dernière valeur de la tension V1 utilisée pour calculer cette valeur courante de la tension V3 est négative.

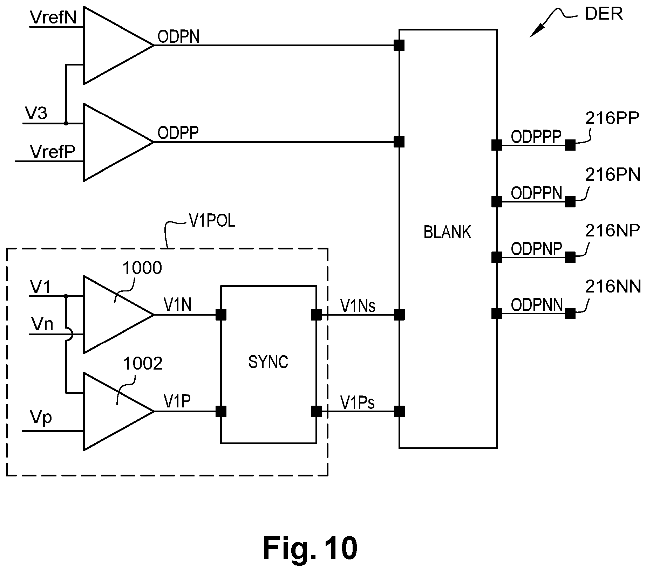

La figure 10 illustre un exemple d'un tel mode de réalisation d'un circuit DER, le circuit DER étant partiellement représenté en figure 10.

A titre d'exemple, bien que cela ne soit pas illustré en figure 10, le circuit DER comprend en outre un circuit CTRL tel que décrit en relation avec la figure 7 ou avec la figure 9.

Dans cet exemple de mode de réalisation, le circuit DER comprend, en plus des comparateurs COMP2N et COMP2P, un circuit V1POL configuré pour indiquer par au moins un signal binaire, par exemple au moyen de deux signaux binaires V1Ns et V1Ps, la polarité de la dernière valeur de la tension V1 utilisée pour calculer la valeur courante de la tension V3. Dit autrement, le circuit V1POL est configuré pour synchroniser des valeurs de la tension V1 avec des valeurs correspondantes de la tension V3, et pour indiquer, par au moins un signal binaire, la polarité de chaque valeur de la tension V1 resynchronisée avec une valeur correspondante de la tension V3.

Par exemple, le signal V1Ps indique par son état binaire si la dernière valeur de la tension V1 utilisée pour calculer la dérivée de la tension V1 est positive ou non. Par exemple, un premier état binaire du signal V1Ps indique que la dernière valeur de tension V1 utilisée pour calculer la dérivée de la tension V1 est strictement positive et un deuxième état binaire du signal V1Ps indique que la dernière valeur de tension V1 utilisée pour calculer la dérivée de la tension V1 est négative ou nulle. De manière symétrique, par exemple, le signal V1Ns indique par son état binaire si la dernière valeur de la tension V1 utilisée pour calculer la dérivée de la tension V1 est négative ou non. Par exemple, un premier état binaire du signal V1Ns indique que la dernière valeur de tension V1 utilisée pour calculer la dérivée de la tension V1 est strictement négative et un deuxième état binaire du signal V1Ns indique que la dernière valeur de tension V1 utilisée pour calculer la dérivée de la tension V1 est positive ou nulle.

Par exemple, lorsque le circuit DER est mis en œuvre selon le premier aspect ou selon le deuxième aspect, le circuit V1POL indique la polarité de la dernière valeur de la tension V1 mémorisée et utilisée pour calculer la valeur courante de la tension V3.

A titre d'exemple plus particulier, dans le deuxième aspect ou le troisième aspect, la valeur courante de la tension V3 est calculée à partir d'une différence entre deux tensions mémorisées sur deux éléments capacitifs correspondants parmi les M éléments capacitifs, et le circuit V1POL indique la polarité de celle des deux tensions qui a été mémorisée en dernier.

Par exemple, lorsque le circuit DER est mis en œuvre selon le troisième aspect, le circuit V1POL indique la polarité de la tension V1 au moment où la valeur de la tension V3 indique une valeur correcte de dérivée de la tension V1. A titre d'exemple, on considère ici que la tension V3 est mise à jour uniquement à des instants où la valeur courante de la tension V1 utilisée pour calculer la tension V3 correspond à une valeur correcte de dérivée.

A titre d'exemple plus particulier, dans le troisième aspect, lorsque les mémorisations de la tension V1 sur l'élément capacitif C1 sont mises en œuvre à chaque front descendant, respectivement montant, de l'horloge interne du circuit DER et que la valeur de la tension V3 est lue à chaque front montant, respectivement descendant, de cette horloge interne pour que le facteur K ait une valeur connue, la valeur de la tension V3 est alors mise à jour à chaque front montant, respectivement descendant de l'horloge interne, et est maintenue à sa valeur courante entre deux mises à jour successives.

A titre d'exemple, le circuit V1POL comprend un comparateur 1000 configuré pour comparer la tension V1 à une tension Vn nulle ou légèrement négative. Par exemple, la tension Vn est comprise dans une plage de valeurs allant de 0 V à -20 mV. La tension Vn est par exemple égale à -5 mV. Le comparateur 1000 est configuré pour fournir un signal binaire V1N indiquant si la tension V1 est supérieure à la tension Vn ou inférieure à la tension Vn. Toujours dans cet exemple, le circuit V1POL comprend un comparateur 1002 configuré pour comparer la tension V1 à une tension Vp nulle ou légèrement positive. Par exemple, la tension Vp est comprise dans une plage de valeurs allant de 0 V à 20 mV. La tension Vp est par exemple égale à 5 mV. Le comparateur 1002 est configuré pour fournir un signal binaire V1P indiquant si la tension V1 est supérieure à la tension Vp ou inférieure à la tension Vp. En plus des comparateurs 1000 et 1002, le circuit V1POL comprend, dans cet exemple, un circuit SYNC configuré pour mémoriser l'état des signaux V1N et V1P sur les signaux binaires respectifs V1Ns et V1Ps, à chaque instant où, dans les premier et deuxième aspects, la tension V1 est mémorisée sur l'un des M éléments capacitifs, ou, dans le troisième aspect, la tension V3 a une valeur pour laquelle la valeur du coefficient K est connue, ou, dit autrement, la valeur de la tension V3 correspond à une valeur correcte de la dérivée de la tension V1.

A titre d'exemple non illustré, les deux comparateurs 1000 et 1002 peuvent être remplacés par un unique comparateur comparant la tension V1 à une tension nulle.

A titre d'autre exemple non illustré, le circuit SYNC est configuré pour mémoriser la valeur de la tension V1 à chaque instant où, dans les premier et deuxième aspects, la tension V1 est mémorisée sur l'un des M éléments capacitifs, ou, dans le troisième aspect, la tension V3 a une valeur pour laquelle la valeur du coefficient K est connue, ou, dit autrement, la valeur de la tension V3 correspond à une valeur correcte de la dérivée de la tension V1. Dans cet autre exemple, la valeur mémorisée de la tension disponible en sortie du circuit SYNC est ensuite comparée aux deux tensions Vn et Vp pour obtenir les signaux V1Ns et V1Ps, ou à une tension nulle pour obtenir un unique signal de sortie du circuit V1POL.

Le circuit DER comprend en outre un circuit combinatoire BLANK configuré pour fournir les signaux d'alarme OPPP et ODPN à partir des signaux ODPP et ODPN ainsi que du ou des signaux de sortie du circuit V1POL. Par exemple, le circuit BLANK reçoit les signaux ODPP et ODPN. Par exemple, le circuit BLANK reçoit le ou les signaux de sortie du circuit V1POL, par exemple les signaux V1NS et V1PS.

Plus particulièrement, le circuit BLANK est configuré pour :
- fournir le signal binaire ODPPP à un premier état binaire indiquant que la dérivée de la tension V1 est supérieure au seuil VrefP si le signal ODPP indique que la tension V3 est supérieure au seuil VrefP alors que la dernière valeur de la tension V1 utilisée pour calculer cette valeur courante de la tension V3 est positive, et à un deuxième état binaire sinon et
- fournir le signal binaire d'alarme ODPNN à un premier état binaire indiquant que la dérivée de la tension V1 est inférieure au seuil VrefN si le signal ODPN indique que la tension V3 est inférieure au seuil VrefN alors que la dernière valeur de la tension V1 utilisée pour calculer cette valeur courante de la tension V3 est négative, et à un deuxième état binaire sinon.

Par exemple, le circuit BLANK est configuré pour :
- fournir le signal binaire ODPPP à un premier état binaire indiquant que la dérivée de la tension V1 est supérieure au seuil VrefP si le signal ODPP indique que la tension V3 est supérieure au seuil VrefP alors que le signal V1Ps est à son premier état binaire, et pour fournir le signal ODPPP à son deuxième état binaire sinon ; et
- fournir le signal binaire d'alarme ODPNN à un premier état binaire indiquant que la dérivée de la tension V1 est inférieure au seuil VrefN si le signal ODPN indique que la tension V3 est inférieure au seuil VrefN alors que le signal V1Ns est à son premier état binaire, et pour fournir le signal ODPPN à son deuxième état binaire sinon.

Les signaux ODPPP et ODPNN sont fournis à des sorties 216PP et 216NN du circuit DER qui ne comprend alors aucunes des sorties 216, 216N et 216P, ces dernières étant remplacées par les sorties 216PP et 216NN.

De manière optionnelle, à partir des signaux ODPP et ODPN et du ou des signaux de sortie du circuit SYNC, le circuit BLANK est en outre configuré pour :
- fournir un signal binaire ODPPN à un premier état binaire indiquant que la dérivée de la tension V1 est supérieure au seuil VrefP si le signal ODPP indique que la tension V3 est supérieure au seuil VrefP alors que la dernière valeur de la tension V1 utilisée pour calculer cette valeur courante de la tension V3 est négative, et à un deuxième état binaire sinon et/ou
- fournir le signal binaire d'alarme ODPNN à un premier état binaire indiquant que la dérivée de la tension V1 est inférieure au seuil VrefN si le signal ODPN indique que la tension V3 est inférieure au seuil VrefN alors que la dernière valeur de la tension V1 utilisée pour calculer cette valeur courante de la tension V3 est négative, et à un deuxième état binaire sinon.

Les signaux ODPPN et ODPPN sont, par exemple, fournis à des sorties respectives 216PN et 216PN du circuit DER.

### Aspects supplémentaires

Dans les circuits DER selon les premier, deuxième et troisième aspects décrits ci-dessus, M est égal respectivement à 3, 2 et 1. Bien que cela résulte en un augmentation de la complexité du circuit DER, la personne du métier pourra prévoir, à partir de la description fonctionnelle donnée ci-dessus, des cinquièmes aspects supplémentaires où M est un entier strictement supérieur à 3.

Par ailleurs, bien que l'on ait décrit un mode de réalisation d'un dispositif 3 dans lequel le circuit DER est mis en œuvre selon le premier aspect avec M qui est égal à 3, la personne du métier sera en mesure d'adapter la description du dispositif 3 au cas d'un circuit DER dans lequel M est égal à 1, 2 ou plus de 3.

Plus généralement, la personne du métier sera en mesure de mettre en œuvre le dispositif 3 dans lequel le circuit DER est mis en œuvre selon l'un quelconque des premier, deuxième, troisième et cinquième aspects, combiné ou non avec le quatrième aspect. En particulier, la personne du métier sera en mesure de modifier le circuit CMD selon que le circuit DER fournisse le signal ODP, le signal ODPP, le signal ODPN, les deux signaux ODPN et ODPP, ou au moins les deux signaux ODPPPP et ODPNN parmi les signaux ODPPP, ODPPN, ODPNP et ODPNN.

Les modes de réalisation du quatrième aspect ont été décrits comme dépendant de l'un quelconque des premier, deuxième, troisième et cinquièmes aspects. Toutefois, ce quatrième aspect peut être mis en œuvre avec d'autres circuits de calcul d'une dérivée d'une grandeur. En effet, la comparaison de la valeur dérivée calculée à un seuil adapté en fonction de la valeur courante de la grandeur sur laquelle est calculée la dérivée pour déclencher une alarme sur la base du résultat de cette comparaison ne nécessite pas que le calcul de dérivée soit basé sur l'un quelconque des premier, deuxième, troisième et cinquième aspects, et pourrait être mise en œuvre par la personne du métier, à partir des indications fonctionnelles données ci-dessus, avec un calcul de dérivée basé sur l'utilisation d'un ADC et/ou d'un microcontrôleur.

Par ailleurs, la personne du métier comprendra que le découpage du circuit DER en plusieurs circuits est uniquement fait à titre illustratif, et que, dans les circuits DER précédemment décrits, plusieurs circuits peuvent être regroupés en un unique circuit et/ou un circuit peut être découpés en plusieurs circuits, dès lors que les fonctionnalités du circuit DER sont conservées.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, comme cela a déjà été indiqué précédemment, l'utilisation du circuit DER ne se limite pas à une mise en œuvre dans le dispositif 3, et, plus largement, à la mesure de la dérivée d'une tension V3 représentative de la valeur d'un courant I.

Enfin, la mise en oeuvre pratique des modes de réalisation et variantes décrits est à la portée de la personne du métier à partir des indications fonctionnelles données ci-dessus.

## Revendications

1. Circuit (DER) de mesure d'une dérivée comprenant :
M éléments capacitifs (C1, C2, C3), avec M un entier supérieur ou égal à 1, ayant chacun une première borne connectée à une première entrée (200) du circuit de mesure configurée pour recevoir un potentiel de référence (GND) ;
M premiers interrupteurs (IT11, IT12, IT13) couplant une deuxième borne de chacun des M éléments à un premier noeud (202) configuré pour recevoir une première tension (V1) déterminée par une tension (V2) sur une deuxième entrée (204) du circuit de mesure couplée au premier noeud ;
un premier circuit (DIFF) configuré pour fournir, à une première sortie (206) du circuit de mesure, une deuxième tension (V3) indiquant une valeur d'une différence de tension entre des première et deuxième entrées (208, 210) du premier circuit ;
des deuxièmes interrupteurs (IT21, IT22, IT23, IT24, IT25, IT26) couplant la deuxième borne de chacun des M éléments aux entrées du premier circuit ; et
un circuit de commande (CTRL) configuré pour :
- recevoir un premier signal d'horloge (clk) disponible sur une troisième entrée (212) du circuit de mesure ;
- mettre en œuvre des cycles successifs correspondant chacun à une succession de M périodes d'un deuxième signal d'horloge déterminé par le premier signal d'horloge ; et
- commander les interrupteurs pour que, à chaque période de chaque cycle :
la première tension (V1) soit mémorisée sur l'un des M éléments capacitifs ; et
la première entrée (208) du premier circuit (DIFF) reçoive une tension mémorisée à un premier instant sur un des M éléments capacitifs et la deuxième entrée (210) du premier circuit (DIFF) reçoive une tension représentative de la première tension (V1) à un deuxième instant différent du premier instant.

2. Circuit selon la revendication 1, dans lequel :
M est égal à 1 ;
la première entrée (208) du premier circuit (DIFF) est couplée au premier noeud (202) ; et
le circuit de commande est configuré pour commander les interrupteurs de sorte que, à chaque période de chaque cycle, la deuxième entrée (210) du premier circuit (DIFF) reçoive la tension mémorisée sur l'élément capacitif (C1) à cette période.

3. Circuit selon la revendication 1, dans lequel :
M est égal à 2 ; et
le circuit de commande est configuré pour commander les interrupteurs de sorte que, pour chaque cycle :
celui des M éléments capacitifs sur lequel est mémorisée la première tension soit différent à chaque période dudit cycle, et
à chaque période dudit cycle, la deuxième entrée (210) du premier circuit (DIFF) reçoive une tension aux bornes d'un des M éléments capacitifs autre que celui sur lequel s'effectue la mémorisation à cette période, et la première entrée (208) du premier circuit (DIFF) reçoive une tension aux bornes de l'autre des M éléments capacitifs.

4. Circuit selon la revendication 1, dans lequel :
M est égal à 3 ; et
le circuit de commande est configuré pour commander les interrupteurs de sorte que, pour chaque cycle :
celui des M éléments capacitifs sur lequel est mémorisée la première tension est différent à chaque période dudit cycle, et
à chaque période dudit cycle, la première entrée (208) du premier circuit (DIFF) reçoive une tension aux bornes d'un des M éléments capacitifs autre que celui sur lequel s'effectue la mémorisation à cette période et la deuxième entrée (210) du premier circuit (DIFF) reçoive une tension aux bornes d'un autre des M éléments capacitifs autre que celui sur lequel s'effectue la mémorisation à cette période.

5. Circuit selon la revendication 1, dans lequel :
M est égal à 3 ;
chaque cycle correspond à une succession de première, deuxième et troisième périodes du deuxième signal d'horloge ; et
le circuit de commande est configuré pour commander les interrupteurs pour que :
à chaque première période, la première tension (V1) soit mémorisée sur le premier élément (C1) et les première et deuxième entrées (208, 210) du premier circuit reçoivent des tensions des troisième et deuxième éléments (C3, C2) respectivement,
à chaque deuxième période, la première tension (V1) soit mémorisée sur le deuxième élément (C2) et les première et deuxième entrées (208, 210) du premier circuit reçoivent des tensions des premier et troisième éléments (C1, C3) respectivement, et
à chaque troisième période, la première tension (V1) soit mémorisée sur le troisième élément (C3) et les première et deuxième entrées (208, 210) du premier circuit reçoivent des tensions des deuxième et premier éléments (C2, C1) respectivement.

6. Circuit selon la revendication 5, dans lequel les premiers interrupteurs comprennent un premier premier interrupteur (IT11) couplant la deuxième borne du premier élément (C1) au premier noeud (202), un deuxième premier interrupteur (IT12) couplant la deuxième borne du deuxième élément (C2) au premier noeud (202) et un troisième premier interrupteur (IT13) couplant la deuxième borne du troisième élément (C3) au premier noeud (202).

7. Circuit selon la revendication 5 ou 6, dans lequel le circuit de commande est configuré pour :
à chaque première période, maintenir ouvert les deuxième et troisième premiers interrupteurs (IT12, IT13) et commuter le premier premier interrupteur (IT11) à l'état passant ;
à chaque deuxième période, maintenir ouvert les troisième et premier premiers interrupteurs (IT11, IT13) et commuter le deuxième premier interrupteur (IT12) à l'état passant ; et
à chaque troisième période, maintenir ouvert les deuxième et premier premiers interrupteurs (IT12, IT11) et commuter le troisième premier interrupteur (IT13) à l'état passant.

8. Circuit selon l'une quelconque des revendications 5 à 7, dans lequel chaque mémorisation de la première tension (V1) sur un élément capacitif a une même durée, par exemple inférieure ou égale à une période du deuxième signal d'horloge, de préférence égale à une demi-période du deuxième signal d'horloge.

9. Circuit selon l'une quelconque des revendications 5 à 8, dans lequel les deuxièmes interrupteurs comprennent :
des premier et deuxième deuxièmes interrupteurs (IT21, IT22) couplant la deuxième borne du premier élément (C1) respectivement aux première et deuxième entrées (208, 210) du premier circuit (DIFF) ;
des troisième et quatrième deuxièmes interrupteurs (IT23, IT24) couplant la deuxième borne du deuxième élément (C2) respectivement aux première et deuxième entrées (208, 210) du premier circuit (DIFF) ; et
des cinquième et sixième deuxièmes interrupteurs (IT25, IT26) couplant la deuxième borne du troisième élément (C3) respectivement aux première et deuxième entrées (208, 210) du premier circuit.

10. Circuit ou dispositif selon la revendication 9, dans lequel le circuit de commande (CTRL) est configuré pour :
à chaque première période, commuter les cinquième et quatrième deuxièmes interrupteurs (IT25, IT24) à l'état passant et maintenir les autres deuxièmes interrupteurs ouverts ;
à chaque deuxième période, commuter les premier et sixième deuxièmes interrupteurs (IT21, IT26) à l'état passant et maintenir les autres deuxièmes interrupteurs ouverts ; et
à chaque troisième période, commuter les troisième et deuxième deuxièmes interrupteurs (IT23, IT22) à l'état passant et maintenir les autres deuxièmes interrupteurs ouverts.

11. Circuit selon l'une quelconque des revendications 1 à 10, dans lequel le circuit de mesure comprend un élément capacitif de lissage (Cp) connecté entre la première entrée (208) du premier circuit (DIFF) et la première entrée (200) du circuit de mesure (DER) et un élément capacitif de lissage (Cm) connecté entre la deuxième entrée (210) du premier circuit (DIFF) et la première entrée (200) du circuit de mesure (DER).

12. Circuit selon l'une quelconque des revendications 1 à 11, dans lequel le circuit de mesure (DER) comprend en outre un deuxième circuit (AMP) couplant la deuxième entrée (204) du circuit de mesure (DER) au premier noeud (202), le deuxième circuit (AMP) étant un circuit tampon.

13. Circuit selon l'une quelconque des revendications 1 à 12, dans lequel le circuit de mesure comprend :
un premier comparateur (COMP2P) configuré pour comparer la deuxième tension (V3) à une tension de seuil positive (VrefP) fournie par le circuit de commande (CTRL), et pour fournir un premier signal binaire (ODPP) indiquant si la deuxième tension est supérieure à la tension de seuil positive ; et/ou
un deuxième comparateur (COMP2N) configuré pour comparer la deuxième tension (V3) à une tension de seuil négative (VrefN) fournie par le circuit de commande (CTRL), et pour fournir un deuxième signal binaire (ODPN) indiquant si la deuxième tension est inférieure à la tension de seuil négative.

14. Circuit selon la revendication 13, dans lequel :
le circuit de mesure (DER) comprend le premier comparateur (COMP2P) ; et
le circuit de commande (CTRL) est configuré pour adapter la valeur de la tension de seuil positive (VrefP) en fonction de la valeur de la première tension (V1).

15. Circuit selon la revendication 14, dans lequel le circuit de commande (CTRL) est configuré pour diminuer la valeur de la tension de seuil positive (VrefP) lorsque la première tension (V1) est positive et augmente.

16. Circuit selon la revendication 13, dans lequel :
le circuit de mesure (DIFF) comprend le deuxième comparateur ; et
le circuit de commande (CTRL) est configuré pour adapter la valeur de la tension de seuil négative (VrefP) en fonction de la valeur de la première tension (V1).

17. Circuit selon la revendication 16, dans lequel le circuit de commande (CTRL) est configuré pour diminuer la valeur absolue de la tension de seuil négative (VrefN) lorsque la première tension (V1) est négative et décroît.

## Patentansprüche

1. Eine Ableitungs-Messschaltung (DER), die Folgendes aufweist:
M kapazitive Elemente (C1, C2, C3), wobei M eine ganze Zahl größer oder gleich 1 ist, die jeweils einen ersten Anschluss haben, der mit einem ersten Eingang (200) der Messschaltung verbunden ist, der konfiguriert ist zum Empfangen eines Referenzpotentials (GND);
M erste Schalter (IT11, IT12, IT13), die einen zweiten Anschluss jedes der M Elemente mit einem ersten Knoten (202) koppeln, der konfiguriert ist zum Empfangen einer ersten Spannung (V1), die durch eine Spannung (V2) an einem zweiten Eingang (204) der Messschaltung bestimmt wird, der mit dem ersten Knoten gekoppelt ist;
eine erste Schaltung (DIFF), die konfiguriert ist zum Liefern, an einem ersten Ausgang (206) der Messschaltung, einer zweiten Spannung (V3), die einen Wert einer Spannungsdifferenz zwischen ersten und zweiten Eingängen (208, 210) der ersten Schaltung anzeigt;
zweite Schalter (IT21, IT22, IT23, IT24, IT25, IT26), die den zweiten Anschluss jedes der M Elemente mit den Eingängen der ersten Schaltung koppeln; und
eine Steuerschaltung (CTRL), konfiguriert zum:
- Empfangen eines ersten Taktsignals (clk), das an einem dritten Eingang (212) der Messschaltung verfügbar ist;
- Implementieren aufeinanderfolgender Zyklen, die jeweils einer Folge von M Perioden eines zweiten Taktsignals entsprechen, das durch das erste Taktsignal bestimmt wird; und
- Steuern der Schalter in einer Weise, sodass bei jeder Periode eines jeden Zyklus:
die erste Spannung (V1) an einem der M kapazitiven Elemente gespeichert wird; und
der erste Eingang (208) der ersten Schaltung (DIFF) eine Spannung empfängt, die zu einem ersten Zeitpunkt an einem der M kapazitiven Elemente gespeichert wird, und der zweite Eingang (210) der ersten Schaltung (DIFF) eine Spannung empfängt, die die erste Spannung (V1) zu einem zweiten Zeitpunkt darstellt, der sich von dem ersten Zeitpunkt unterscheidet.

2. Schaltung nach Anspruch 1, wobei:
M gleich 1 ist;
der erste Eingang (208) der ersten Schaltung (DIFF) mit dem ersten Knoten (202) gekoppelt ist; und
die Steuerschaltung (CTRL) konfiguriert ist zum Steuern der Schalter in einer Weise, sodass in jeder Periode jedes Zyklus der zweite Eingang (210) der ersten Schaltung (DIFF) die Spannung empfängt, die an dem kapazitiven Element (C1) in dieser Periode gespeichert ist.

3. Schaltung nach Anspruch 1, wobei:
M gleich 2 ist; und
die Steuerschaltung (CTRL) konfiguriert ist zum Steuern der Schalter in einer Weise, sodass bei jedem Zyklus:
dasjenige der M kapazitiven Elemente, an dem die erste Spannung gespeichert ist, bei jeder Periode des Zyklus unterschiedlich ist, und
in jeder Periode des Zyklus der zweite Eingang (210) der ersten Schaltung (DIFF) eine Spannung an den Anschlüssen eines der M kapazitiven Elemente empfängt, das nicht dasjenige ist, an dem die Speicherung in diesem Zyklus erfolgt, und der erste Eingang (208) der ersten Schaltung (DIFF) eine Spannung an dem anderen der M kapazitiven Elemente empfängt.

4. Schaltung nach Anspruch 1, wobei:
M gleich 3 ist; und
die Steuerschaltung (CTRL) konfiguriert ist zum Steuern der Schalter in einer Weise, sodass bei jedem Zyklus:
dasjenige der M kapazitiven Elemente, an dem die erste Spannung gespeichert ist, bei jeder Periode des Zyklus unterschiedlich ist, und
in jeder Periode des Zyklus der erste Eingang (210) der ersten Schaltung (DIFF) eine Spannung an den Anschlüssen eines der M kapazitiven Elemente empfängt, das nicht dasjenige ist, an dem die Speicherung in diesem Zyklus erfolgt, und der zweite Eingang (210) der ersten Schaltung (DIFF) eine Spannung an einem anderen der M kapazitiven Elemente empfängt, das nicht dasjenige ist, an dem die Speicherung in dieser Periode erfolgt.

5. Schaltung nach Anspruch 1, wobei:
M gleich 3 ist;
jeder Zyklus einer Folge von ersten, zweiten und dritten Perioden des zweiten Taktsignals entspricht; und
die Steuerschaltung konfiguriert ist zum Steuern des Schalters in einer Weise, sodass:
bei jeder ersten Periode die erste Spannung (V1) am ersten Element (C1) gespeichert wird und der erste und der zweite Eingang (208, 210) der ersten Schaltung Spannungen des dritten bzw. zweiten Elements (C3, C2) empfangen, bei jeder zweiten Periode die erste Spannung (V1) am zweiten Element (C2) gespeichert wird und der erste und der zweite Eingang (208, 210) der ersten Schaltung Spannungen des ersten bzw. des dritten Elements (C1, C3) empfangen, und
bei jeder dritten Periode die erste Spannung (V1) am dritten Element (C3) gespeichert wird und der erste und der zweite Eingang (208, 210) der ersten Schaltung Spannungen des zweiten bzw. des ersten Elements (C2, C1) empfangen.

6. Schaltung nach Anspruch 5, wobei die ersten Schalter einen ersten ersten Schalter (IT11) aufweisen, der den zweiten Anschluss des ersten Elements (C1) mit dem ersten Knoten (202) koppelt, einen zweiten ersten Schalter (IT12), der den zweiten Anschluss des zweiten Elements (C2) mit dem ersten Knoten (202) koppelt, und einen dritten ersten Schalter (IT13), der den zweiten Anschluss des dritten Elements (C3) mit dem ersten Knoten (202) koppelt.

7. Schaltung nach Anspruch 5 oder 6, wobei die Steuerschaltung konfiguriert ist zum:
bei jeder ersten Periode, Offenhalten der zweiten und dritten ersten Schalter (IT12, IT13) und Schalten des ersten ersten Schalters (IT11) in den EIN-Zustand;
bei jeder zweiten Periode, Offenhalten der dritten und ersten ersten Schalter (IT13, IT11) und Schalten des zweiten ersten Schalters (IT12) in den EIN-Zustand; und
bei jeder dritten Periode, Offenhalten der zweiten und ersten ersten Schalter (IT12, IT11) und Schalten des dritten ersten Schalters (IT13) in den EIN-Zustand.

8. Schaltung nach einem der Ansprüche 5 bis 7, wobei jede Speicherung der ersten Spannung (V1) an einem kapazitiven Element die gleiche Dauer hat, z.B. weniger als oder gleich einer Periode des zweiten Taktsignals, vorzugsweise gleich einer halben Periode des zweiten Taktsignals.

9. Die Schaltung nach einem der Ansprüche 5 bis 8, wobei die zweiten Schalter Folgendes aufweisen:
einen ersten und einen zweiten zweiten Schalter (IT21, IT22), die den zweiten Anschluss des ersten Elements (C1) mit dem ersten bzw. dem zweiten Eingang (208, 210) der ersten Schaltung (DIFF) koppeln;
einen dritten und vierten zweiten Schalter (IT23, IT24), die den zweiten Anschluss des zweiten Elements (C2) mit dem ersten bzw. zweiten Eingang (208, 210) der ersten Schaltung (DIFF) koppeln; und
einen fünften und sechsten zweiten Schalter (IT25, IT26), die den zweiten Anschluss des dritten Elements (C3) mit dem ersten bzw. dem zweiten Eingang (208, 210) der ersten Schaltung koppeln.

10. Schaltung oder Vorrichtung nach Anspruch 9, wobei die Steuerschaltung (CTRL) konfiguriert ist zum:
bei jeder ersten Periode, Schalten des fünften und vierten zweiten Schalters (IT25, IT24) in den EIN-Zustand und Offenhalten der anderen zweiten Schalter;
bei jeder zweiten Periode, Schalten des ersten und sechsten zweiten Schalters (IT21, IT26) in den EIN-Zustand und Offenhalten der anderen zweiten Schalter; und
bei jeder dritten Periode, Schalten des dritten und zweiten zweiten Schalters (IT23, IT22) in den EIN-Zustand und Offenhalten der anderen zweiten Schalter.

11. Schaltung nach einem der Ansprüche 1 bis 10, wobei die Messschaltung ein kapazitives Glättungselement (Cp) aufweist, das zwischen dem ersten Eingang (208) der ersten Schaltung (DIFF) und dem ersten Eingang (200) der Messschaltung (DER) angeschlossen ist, und ein kapazitives Glättungselement (Cm) aufweist, das zwischen dem zweiten Eingang (210) der ersten Schaltung (DIFF) und dem ersten Eingang (200) der Messschaltung (DER) angeschlossen ist.

12. Schaltung nach einem der Ansprüche 1 bis 11, wobei die Messschaltung (DER) ferner eine zweite Schaltung (AMP) aufweist, die den zweiten Eingang (204) der Messschaltung (DER) mit dem ersten Knoten (202) koppelt, wobei die dritte Schaltung (AMP) eine Pufferschaltung ist.

13. Schaltung nach einem der Ansprüche 1 bis 12, wobei die Messschaltung (DER) Folgendes aufweist:
einen ersten Komparator (COMP2P), der konfiguriert ist zum Vergleichen der zweiten Spannung (V3) mit einer positiven Schwellenwertspannung (VrefP), die von der Steuerschaltung (CTRL) bereitgestellt wird, und zum Bereitstellen eines ersten Binärsignals (ODPP), das anzeigt, ob die zweite Spannung größer ist als die positive Schwellenwertspannung; und/oder
einen zweiten Komparator (COMP2P), der konfiguriert ist zum Vergleichen der zweiten Spannung (V3) mit einer negativen Schwellenwertspannung (VrefN), die von der Steuerschaltung (CTRL) bereitgestellt wird, und zum Bereitstellen eines zweiten Binärsignals (ODPN), das anzeigt, ob die zweite Spannung niedriger als die positive Schwellenwertspannung ist.

14. Die Schaltung nach Anspruch 13, wobei:
die Messschaltung (DER) den ersten Komparator (COMP2P) aufweist; und
die Steuerschaltung (CTRL) konfiguriert ist zum Anpassen eines Wertes der positiven Schwellenwertspannung (VrefP) in Abhängigkeit von einem Wert der ersten Spannung (V1).

15. Schaltung nach Anspruch 14, wobei die Steuerschaltung (CTRL) konfiguriert ist zum Verringern des Wertes der positiven Schwellenwertspannung (VrefP), wenn die erste Spannung (V1) positiv ist und ansteigt.

16. Schaltung nach Anspruch 13, wobei:
die Messschaltung (DER) den zweiten Komparator (COMP2N) aufweist; und
die Steuerschaltung (CTRL) konfiguriert ist zum Anpassen eines Wertes der negativen Schwellenwertspannung (VrefN) in Abhängigkeit von einem Wert der ersten Spannung (V1).

17. Schaltung nach Anspruch 16, wobei die Steuerschaltung (CTRL) konfiguriert ist zum Verringern des Absolutwertes der negativen Schwellenwertspannung (VrefN), wenn die erste Spannung (V1) negativ ist und abnimmt.

## Claims

1. A derivative measurement circuit (DER), comprising:
M capacitive elements (C1, C2, C3), M being an integer superior or equal to 1, having each a first terminal connected to a first input (200) of the measurement circuit configured to receive a reference potential (GND);
M first switches (IT11, IT12, IT13) coupling a second terminal of each of the M elements to a first node (202) configured to receive a first voltage (V1) determined by a voltage (V2) at a second input (204) of the measurement circuit coupled with the first node;
a first circuit (DIFF) configured to deliver, at a first output (206) of the measurement circuit, a second voltage (V3) indicating a value of a voltage difference between first and second inputs (208, 210) of the first circuit;
second switches (IT21, IT22, IT23, IT24, IT25, IT26) coupling the second terminal of each of the M elements to the inputs of the first circuit; and
a control circuit (CTRL) configured to:
- receive a first clock signal (clk) available at a third input (212) of the measurement circuit;
- implement successive cycles corresponding each to a succession of M periods of a second clock signal determined by the first clock signal; and
- control the switches such a way that, at each period of each cycle:
the first voltage (V1) is memorized on one of the M capacitive elements; and
the first input (208) of the first circuit (DIFF) receives a voltage memorized at a first instant on one of the M capacitive elements and the second input (210) of the first circuit (DIFF) receives a voltage representative of the first voltage (V1) at a second instant different from the first instant.

2. Circuit according to claim 1, wherein:
M is equal to 1;
the first input (208) of the first circuit (DIFF) is coupled to the first node (202); and
the control circuit (CTRL) is configured to control the switches such a way that, at each period of each cycle, the second input (210) of the first circuit (DIFF) receives the voltage memorized on the capacitive element (C1) at this period.

3. Circuit according to claim 1, wherein:
M is equal to 2; and
the control circuit (CTRL) is configured to control the switches such a way that, at each cycle:
that of the M capacitive elements on which the first voltage is memorized is different at each period of the cycle, and
at each period of the cycle, the second input (210) of the first circuit (DIFF) receives a voltage across the terminals of one of the M capacitive elements other than the one on which the memorization is done at this cycle, and the first input (208) of the first circuit (DIFF) receives a voltage across the other of the M capacitive elements.

4. Circuit according to claim 1, wherein:
M is equal to 3; and
the control circuit (CTRL) is configured to control the switches such a way that, at each cycle:
that of the M capacitive elements on which the first voltage is memorized is different at each period of the cycle, and
at each period of the cycle, the first input (210) of the first circuit (DIFF) receives a voltage across the terminals of one of the M capacitive elements other than the one on which the memorization is done at this cycle, and the second input (210) of the first circuit (DIFF) receives a voltage across of another of the M capacitive elements other than the one on which the memorization is done at this period.

5. Circuit according to claim 1, wherein:
M is equal to 3;
each cycle corresponds to a succession of first, second and third periods of the second clock signal; and
the control circuit is configured to control the switch in such a way that:
at each first period, the first voltage (V1) is memorized on the first element (C1) and the first and second inputs (208, 210) of the first circuit receive voltages of the third and second elements (C3, C2), respectively,
at each second period, the first voltage (V1) is memorized on the second element (C2) and the first and second inputs (208, 210) of the first circuit receive voltages of the first and third elements (C1, C3), respectively, and
at each third period, the first voltage (V1) is memorized on the third element (C3) and the first and second inputs (208, 210) of the first circuit receive voltages of the second and first elements (C2, C1), respectively.

6. The circuit according to claim 5, wherein the first switches comprise a first first switch (IT11) coupling the second terminal of the first element (C1) with the first node (202), a second first switch (IT12) coupling the second terminal of the second element (C2) with the first node (202), and a third first switch (IT13) coupling the second terminal of the third element (C3) with the first node (202).

7. The circuit according to claim 5 or 6, wherein the control circuit is configured to:
at each first period, keep open the second and third first switches (IT12, IT13) and switch the first first switch (IT11) to the ON state;
at each second period, keep open the third and first first switches (IT13, IT11) and switch the second first switch (IT12) to the ON state; and
at each third period, keep open the second and first first switches (IT12, IT11) and switch the third first switch (IT13) to the ON state.

8. The circuit according to any of claims 5 to 7, wherein each memorization of the first voltage (V1) on a capacitive element has a same duration, for example less than or equal to one period of the second clock signal, preferably equal to half a period of the second clock signal.

9. The circuit according to any of claims 5 to 8, wherein the second switches comprise:
first and second second switches (IT21, IT22) coupling the second terminal of the first element (C1) respectively with the first and second inputs (208, 210) of the first circuit (DIFF) ;
third and fourth second switches (IT23, IT24) coupling the second terminal of the second element (C2) respectively with the first and second inputs (208, 210) of the first circuit (DIFF); and
fifth and sixth second switches (IT25, IT26) coupling the second terminal of the third element (C3) respectively with the first and second inputs (208, 210) of the first circuit.

10. The circuit or device according to claim 9, wherein the control circuit (CTRL) is configured to:
at each first period, switch the fifth and fourth second switches (IT25, IT24) to the ON state and keep open the other second switches;
at each second period, switch the first and sixth second switches (IT21, IT26) to the ON state and keep open the other second switches; and
at each third period, switch the third and second second switches (IT23, IT22) to the ON state and keep open the other second switches.

11. The circuit according to any of claims 1 to 10, wherein the measurement circuit comprises a smoothing capacitive element (Cp) connected between the first input (208) of the first circuit (DIFF) and the first input (200) of the measurement circuit (DER) and a smoothing capacitive element (Cm) connected between the second input (210) of the first circuit (DIFF) and the first input (200) of the measurement circuit (DER).

12. The circuit according to any of claims 1 to 11, wherein the measurement circuit (DER) further comprises a second circuit (AMP) coupling the second input (204) of the measurement circuit (DER) with the first node (202), the third circuit (AMP) being a buffer circuit.

13. The circuit according to any of claims 1 to 12, wherein the measurement circuit (DER) comprises:
a first comparator (COMP2P) configured to compare the second voltage (V3) with a positive threshold voltage (VrefP) provided by the control circuit (CTRL), and to provide a first binary signal (ODPP) indicating if the second voltage is greater than the positive threshold voltage; and/or
a second comparator (COMP2P) configured to compare the second voltage (V3) with a negative threshold voltage (VrefN) provided by the control circuit (CTRL), and to provide a second binary signal (ODPN) indicating if the second voltage is lower than the positive threshold voltage.

14. The circuit according to claim 13, wherein:
the measurement circuit (DER) comprises the first comparator (COMP2P); and
the control circuit (CTRL) is configured to adapt a value of the positive threshold voltage (VrefP) as a function of a value of the first voltage (V1).

15. The circuit according to claim 14, wherein the control circuit (CTRL) is configured to decrease the value of the positive threshold voltage (VrefP) when the first voltage (V1) is positive and increases.

16. The circuit according to claim 13, wherein:
the measurement circuit (DER) comprises the second comparator (COMP2N); and
the control circuit (CTRL) is configured to adapt a value of the negative threshold voltage (VrefN) as a function of a value of the first voltage (V1).

17. The circuit according to claim 16, wherein the control circuit (CTRL) is configured to decrease the absolute value of the negative threshold voltage (VrefN) when the first voltage (V1) is negative and decreases.
